# EUROPÄISCHE PATENTSCHRIFT

(11) **EP 3 610 315 B1**
(45) Veröffentlichungstag und Bekanntmachung des Hinweises auf die Patenterteilung: **10.03.2021**
(21) Anmeldenummer: 18717835.5
(22) Anmeldetag: 09.04.2018
(51) Int. Cl.: G02B 26/08, G02B 7/182, G02B 7/192

(54) **MIKROMECHANISCHE SPIEGELVORRICHTUNG**
MICROMECHANICAL MIRROR DEVICE
DISPOSITIF DE MIROIRS MICROMÉCANIQUE

(30) Priorität: 11.04.2017 DE 102017206252
(43) Veröffentlichungstag der Anmeldung: 19.02.2020
(60) Teilanmeldung: 21155073.6
(73) Patentinhaber: Fraunhofer-Gesellschaft zur Förderung der angewandten Forschung e.V., 80686 München (DE)
(72) Erfinder: GRASSHOFF, Thomas, 01129 Dresden (DE)
(74) Vertreter: Schenk, Markus
(86) Internationale Anmeldenummer: PCT/EP2018/025104
(87) Internationale Veröffentlichungsnummer: WO 2018/188810

(56) Entgegenhaltungen:
- EP-A1- 1 757 972
- WO-A1-2015/075222
- US-A1- 2011 261 431
- US-A1- 2014 028 152

## Beschreibung

Die Erfindung betrifft eine mikromechanische Spiegelvorrichtung, welche einen plattenförmigen Spiegel mit einer Reflexionsfläche zum Reflektieren von Licht umfasst, welcher mittels elektrischer Kräfte in einen resonanten Schwingungszustand bringbar ist, so dass einfallendes Licht in Abhängigkeit von der jeweiligen hin und her gehenden Auslenkung des plattenförmigen Spiegels reflektiert werden kann. Derartige mikromechanische Spiegelvorrichtungen werden auch MEMS-Scannerspiegel genannt.

Mikromechanische Spiegelvorrichtungen der hier beschriebenen Art werden häufig in optischen Anwendungen mit Ablenkeinheiten für Lichtstrahlen verwendet, bei denen Auslenkungen mit vergleichsweise großen Frequenzen und/oder großen Aperturen bzw. Reflexionsflächen gefordert sind. Problematisch ist hier, dass es bei der üblichen Dimensionierung der plattenförmigen Spiegel im Betrieb zu Verformungen bzw. Deformationen der plattenförmigen Spiegel kommt, die je nach gewählter Frequenz, Apertur und Auslenkung vom Nanometer- bis zum Mikrometerbereich reichen können. Diese Deformationen führen dann wiederum zu einer unerwünschten Beeinflussung des Reflexionsverhaltens der jeweiligen plattenförmigen Spiegel. Dabei können die Deformationen der plattenförmigen Spiegel im Betrieb einen anwendungsspezifischen Wert überschreiten, wodurch der Anwendungsbereich entweder eingeschränkt wird oder die Anwendung an sich nicht mehr möglich ist.

Die Dokumente [1] bis [11] beschreiben jeweils unterschiedliche vorbekannte mikromechanische Spiegelvorrichtungen.

Die Aufgabe der vorliegenden Erfindung besteht darin, eine verbesserte mikromechanische Spiegelvorrichtung bereitzustellen.

Die Aufgabe wird gelöst durch eine mikromechanische Spiegelvorrichtung gemäß Anspruch 1.

Der Begriff "plattenförmig" bezieht sich dabei auf die grundsätzliche Form des Spiegels, welche derart ist, dass der Spiegel im Vergleich zu einer Länge und einer Breite eine wesentlich geringere Dicke aufweist. Der Spiegel bzw. seine Reflexionsfläche kann dabei elliptisch, insbesondere rund, oder mehreckig, insbesondere rechteckig oder quadratisch ausgebildet sein. Die Reflexionsfläche kann derart an die Art des einfallenden Lichts angepasst sein, so dass ein hoher Reflexionsgrad erreicht wird. Das Licht kann prinzipiell von jeder Lichtquelle stammen, insbesondere jedoch von einem Laser. Der Ruhezustand ist derjenige Zustand, den die mikromechanische Spiegelvorrichtung einnimmt, wenn der plattenförmige Spiegel und die geschlossene Rahmenstruktur nicht durch elektrische Kräfte ausgelenkt sind.

Der Begriff "geschlossen" bezieht sich hierbei auf die grundsätzliche Form der Rahmenstruktur, welche derart ist, dass sie nach Art eines Ringes ausgebildet ist, so dass Kräfte, welche an einem beliebigen Punkt in den Rahmen eingeleitet werden, sich zu beiden Seiten längs des Rings verteilen können. Dabei bezieht sich der Begriff "vollständig umrahmt" darauf, dass die Rahmenstruktur den Spiegel ohne Unterbrechung vollständig umringt.

Die Federstrukturen sind so ausgebildet, dass sie die geschlossene Rahmenstruktur und den daran angeordneten Spiegel bei einer Auslenkung aus ihrer Ruhelage mittels Federkräften zurück in ihre Ruhelage drängen. Die ortsfeste Tragstruktur kann mehrere Abschnitte aufweisen, wobei jede der Federstrukturen an wenigstens einem der Abschnitte der Tragstruktur befestigt ist.

Die Anregung des resonanten Schwingungszustandes kann mit bekannten elektrischen Antrieben erfolgen, welche elektrostatische, elektromagnetische oder piezoelektrische Kräfte erzeugen, welche auf den geschlossenen Rahmen und/oder auf den plattenförmigen Spiegel periodisch wirken.

Die Verbindungsfederstrukturen stellen die Verbindung zwischen dem plattenförmigen Spiegel und der geschlossenen Rahmenstruktur her. Die Verbindung erfolgt derart elastisch, dass sich die Verbindungsfederstrukturen im resonanten Schwingungszustand periodisch verformen, so dass der plattenförmige Spiegel von der geschlossenen Rahmenstruktur teilweise mechanisch entkoppelt ist. Letzteres bedeutet, dass eine relative Bewegung eines an eine der Verbindungsstrukturen angrenzenden Bereichs des Spiegels gegenüber eines an die jeweilige Verbindungsstruktur angrenzenden Bereichs der Rahmenstruktur möglich ist, sofern sich die Spiegelvorrichtung im resonanten Schwingungszustand befindet. Die Verbindungsfederstrukturen sind derart elastisch verformbar ausgebildet und angeordnet, dass der plattenförmige Spiegel von einer in dem resonanten Schwingungszustand auftretenden dynamischen Verformung der geschlossenen Rahmenstruktur zumindest teilweise entkoppelt ist.

Der plattenförmige Spiegel, die geschlossene Rahmenstruktur, die Federanordnung und die Verbindungsanordnung können jeweils oder insgesamt einstückig ausgebildet sein. Der plattenförmige Spiegel, die geschlossene Rahmenstruktur, die Federanordnung und die Verbindungsanordnung können aber auch jeweils oder insgesamt dadurch hergestellt werden, dass mehrere Einzelteile gefertigt werden, welche dann, beispielsweise stoffschlüssig, zusammengefügt werden. Die Erstreckungen in z-Richtung, also die Höhen, des plattenförmigen Spiegels, der geschlossenen Rahmenstruktur der Federanordnung und der Verbindungsanordnung können auf der Ebene der genannten Bauteile oder auf der Ebene der Gesamtheit der genannten Bauteile einheitlich oder unterschiedlich sein.

Die Deformation eines endlich steifen plattenförmigen Spiegels im resonanten Schwingungszustand wird als dynamische Deformation bezeichnet und ist im Umkehrpunkt der Schwingung am größten. Sie setzt sich allgemein aus einer "federabhängigen" Deformation, welche durch eine Einwirkung von Federkräften und/oder Federmomenten der Federanordnung auf den plattenförmigen Spiegel hervorgerufen wird, und einer "plattenabhängigen" Deformation, welche durch Trägheitskräfte und/oder Trägheitsmomente hervorgerufen wird, zusammen.

Die "federabhängige" Deformation kann insbesondere bei hohen Resonanzfrequenzen und großen Spiegeln nicht vernachlässigt werden, da bei steigender Resonanzfrequenz und steigender Größe des Spiegels die notwendige Steifigkeit der Federanordnung steigt und die erreichbare Steifigkeit des plattenförmigen Spiegels gleichzeitig abnimmt.

Die erfindungsgemäße Kombination mit der geschlossenen Rahmenstruktur, mit der Federanordnung mit den mindestens zwei Federstrukturen und mit der Verbindungsanordnung mit mindestens vier Verbindungsfederstrukturen bewirkt nun, dass die Federkräfte und/oder Federmomente der Federanordnung nicht unmittelbar auf den plattenförmigen Spiegel wirken. Vielmehr werden die Federkräfte und/oder Federmomente der Federanordnung zunächst auf die geschlossene Rahmenstruktur übertragen. Von dort werden sie als Koppelkräfte und/oder Koppelmomente verteilt über wenigstens vier Verbindungsfederstrukturen auf dem plattenförmigen Spiegel übertragen wobei der plattenförmige Spiegel durch die Elastizität der Verbindungsfederstrukturen von der geschlossenen Rahmenstruktur teilweise mechanisch entkoppelt ist.

Praktische Versuche und Modellrechnungen haben nun gezeigt, dass die maximale dynamische Deformation des plattenförmigen Spiegels der erfindungsgemäßen mikromechanischen Spiegelvorrichtung deutlich geringer ist, als bei herkömmlichen mikromechanischen Spiegelvorrichtungen, bei denen die Federkräfte und/oder Federmomente der Federanordnung direkt, also ohne Zwischenschaltung einer Rahmenstruktur, auf den plattenförmigen Spiegel wirken. Weitere praktische Versuche und Modellrechnungen haben gezeigt, dass die maximale dynamische Deformation des plattenförmigen Spiegels der erfindungsgemäßen mikromechanischen Spiegelvorrichtung ebenfalls deutlich geringer ist, als bei mikromechanischen Spiegelvorrichtungen, welche einen offene Rahmenstruktur aufweisen. Weitere praktische Versuche und Modellrechnungen haben gezeigt, dass die maximale dynamische Deformation des plattenförmigen Spiegels der erfindungsgemäßen mikromechanischen Spiegelvorrichtung deutlich geringer ist, als bei mikromechanischen Spiegelvorrichtungen, welche eine starre, also nicht elastische, Verbindung zwischen dem plattenförmigen Spiegel und der Rahmenstruktur aufweisen. Letzteres dürfte darauf beruhen, dass durch die Elastizität der Verbindungsfederstrukturen verhindert wird, dass eine dynamische Verformung der Rahmenstruktur, welche aufgrund der endlichen Steifheit der Rahmenstruktur nie ganz ausgeschlossen werden kann, zu einer dynamischen Verformung des plattenförmigen Spiegels beiträgt.

Insgesamt bewirkt die Erfindung, dass - bei gegebener Reflexionsfläche des Spiegels und bei gegebener Resonanzfrequenz - die maximale dynamische Deformation des plattenförmigen Spiegels im Vergleich zu anderen Lösungen verringert wird, da die erfindungsgemäße Merkmalskombination bewirkt, dass sich die "plattenabhängige" Deformation und die "federabhängige" Deformation zumindest teilweise kompensieren. Umgekehrt bewirkt die Erfindung, dass - bei gegebener Deformation - die Reflexionsfläche und/oder die Resonanzfrequenz erhöht werden kann.

Gemäß der Erfindung sind wenigstens zwei Verbindungsfederstrukturen der Verbindungsfederstrukturen derart angeordnet und derart elastisch verformbar ausgebildet, dass sie in dem resonanten Schwingungszustand um eine aus Richtung der z-Achse gesehen quer zu dem Rand des plattenförmigen Spiegels verlaufende Torsionsachse hin und her tordieren. Auf diese Weise kann die Übertragung von Koppelmomenten von der geschlossenen Rahmenstruktur auf den plattenförmigen Spiegel verhindert oder wenigstens verringert werden, welche durch eine dynamische Verformung der geschlossenen Rahmenstruktur erzeugt werden, so dass die dynamische Verformung des plattenförmigen Spiegels im resonanten Schwingungszustand verringert werden kann. In diesem Ausführungsbeispiel übernimmt die jeweilige Verbindungsfederstruktur die Aufgabe einer Torsionsfeder.

Nach der Erfindung sind wenigstens zwei Verbindungsfederstrukturen der Verbindungsfederstrukturen derart angeordnet und derart elastisch verformbar ausgebildet, dass an der jeweiligen Verbindungsfederstruktur in dem resonanten Schwingungszustand ein hin und her gehender Versatz zwischen der geschlossenen Rahmenstruktur und dem plattenförmigen Spiegel in einer parallel zu der z-Achse verlaufenden Versatzrichtung auftritt. Auf diese Weise kann die Übertragung von Koppelkräften von der geschlossenen Rahmenstruktur auf den plattenförmigen Spiegel verhindert oder wenigstens verringert werden, welche durch eine dynamische Verformung der geschlossenen Rahmenstruktur erzeugt werden, so dass die dynamische Verformung des plattenförmigen Spiegels im resonanten Schwingungszustand verringert werden kann. In diesem Ausführungsbeispiel übernimmt die jeweilige Verbindungsfederstruktur die Aufgabe einer Biegefeder.

Selbstverständlich können die wenigstens zwei Verbindungsfederstrukturen auch so ausgebildet sein, dass sie im resonanten Schwingungszustand gleichzeitig hin und her tordieren und einen hin und her gehenden Versatz ermöglichen. In diesem Ausführungsbeispiel übernimmt die jeweilige Verbindungsfederstruktur sowohl die Aufgabe einer Biegefeder als auch die Aufgabe einer Torsionsfeder.

Gemäß der Erfindung sind wenigstens vier der Verbindungsfederstrukturen an ihrer dem Ursprung abgewandten Seite jeweils durch eine erste Öffnung von der geschlossenen Rahmenstruktur getrennt. Bei der ersten Öffnung kann es sich jeweils insbesondere um eine in z-Richtung gesehen durch die geschlossene Rahmenstruktur hindurchgehende Ausnehmung handeln. In der xy-Ebene betrachtet kann die erste Öffnung länglich ausgebildet und sich dabei längs des Randes des plattenförmigen Spiegels erstrecken. Die erste Öffnung kann dazu dienen, die mechanische Kopplung der jeweiligen Verbindungsfederstruktur und der geschlossenen Rahmenstruktur zu verringern, so dass die gewünschte Elastizität der Verbindung zwischen der geschlossenen Rahmenstruktur und dem plattenförmigen Spiegel, also die gewünschte Elastizität der Verbindungsfederstrukturen, erzielt wird, umso die dynamische Verformung des plattenförmigen Spiegels zu verringern.

Nach einer zweckmäßigen Weiterbildung der Erfindung sind wenigstens zwei der Verbindungsfederstrukturen an ihrer dem Ursprung zugewandten Seite jeweils durch eine zweite Öffnung von dem plattenförmigen Spiegel getrennt. Bei der zweiten Öffnung kann es sich jeweils insbesondere um eine in z-Richtung gesehen durch die geschlossene Rahmenstruktur hindurchgehende Ausnehmung handeln. In der xy-Ebene betrachtet kann die zweite Öffnung länglich ausgebildet und sich dabei längs des Randes des plattenförmigen Spiegels erstrecken. Die zweite Öffnung kann dazu dienen, die mechanische Kopplung der jeweiligen Verbindungsfederstruktur und des plattenförmigen Spiegels zu verringern, so dass die gewünschte Elastizität der Verbindung zwischen der geschlossenen Rahmenstruktur und dem plattenförmigen Spiegel, also die gewünschte Elastizität der Verbindungsfederstrukturen, erzielt wird, umso die dynamische Verformung des plattenförmigen Spiegels zu verringern.

Dabei sind Ausführungsbeispiele möglich, bei denen den wenigstens zwei Verbindungsfederstrukturen jeweils eine erste Öffnung und eine zweite Öffnung zugeordnet sind.

Nach der Erfindung sind, aus der Richtung der z-Achse gesehen, mindestens vier der Verbindungsfederstrukturen derart T-förmig ausgebildet, dass sie jeweils drei Balkenfederabschnitte mit jeweils einem ersten Endbereich und einem zweiten Endbereich aufweisen, wobei die drei Balkenfederabschnitte an den ersten Endbereichen miteinander verbunden sind, wobei ein erster Balkenfederabschnitt der Balkenfederabschnitte quer zum Rand des plattenförmigen Spiegels verläuft. Derartige T-förmige Verbindungsfederstrukturen können sowohl die Aufgabe einer Biegefeder als auch die Aufgabe einer Torsionsfeder übernehmen. Dabei benötigen sie in der xy-Ebene betrachtet nur eine geringe Fläche.

Gemäß der Erfindung ist der erste Balkenfederabschnitt an dem zweiten Endbereich mit dem plattenförmigen Spiegel verbunden, wobei ein zweiter Balkenfederabschnitt und ein dritter Balkenfederabschnitt der Balkenfederabschnitte jeweils entlang des Randes des plattenförmigen Spiegels verlaufen und jeweils an dem zweiten Endbereich mit der geschlossenen Rahmenstruktur verbunden sind. Da der zweite Balkenfederabschnitt und der dritte Balkenfederabschnitt auf der dem plattenförmigen Spiegel abgewandten Seite der jeweiligen Verbindungsfederstruktur angeordnet sind, wird hierdurch die Größe der Reflexionsfläche nicht beeinträchtigt

Gemäß der Erfindung sind die zweiten Balkenfederabschnitte und die dritten Balkenfederabschnitte der T-förmigen Verbindungsfederstrukturen, welche jeweils entlang des Randes des plattenförmigen Spiegels verlaufen, an ihrer dem Ursprung abgewandten Seite jeweils durch eine erste Öffnung von der geschlossenen Rahmenstruktur getrennt. Da die erste Öffnung auf der dem Ursprung abgewandten Seite der Verbindungsfederstruktur, also auch auf der dem plattenförmigen Spiegel abgewandten Seite der Verbindungsfederstruktur, vorgesehen ist, wird hierdurch die Größe der Reflexionsfläche nicht beeinträchtigt.

Gemäß einer vorteilhaften Weiterbildung der Erfindung sind die zweiten Balkenfederabschnitte und dritten Balkenfederabschnitte der T-förmigen Verbindungsfederstrukturen, welche jeweils entlang des Randes des plattenförmigen Spiegels verlaufen, an ihrer dem Ursprung zugewandten Seite jeweils durch eine zweite Öffnung von dem plattenförmigen Spiegel getrennt.

Insgesamt hatte sich gezeigt, dass sich T-förmige Verbindungsfederstrukturen günstig auf die dynamische Verformung des plattenförmigen Spiegels auswirken.

Gemäß einer vorteilhaften Weiterbildung der Erfindung sind, aus der Richtung der z-Achse gesehen, mindestens zwei der Verbindungsfederstrukturen derart H-förmig ausgebildet, dass sie jeweils fünf Balkenfederabschnitte mit jeweils einem ersten Endbereich und einem zweiten Endbereich aufweisen, wobei ein erster Balkenfederabschnitt der Balkenfederabschnitte quer zum Rand des plattenförmigen Spiegels verläuft, wobei der erste Endbereich des ersten Balkenfederabschnittes mit den ersten Endbereichen eines zweiten Balkenfederabschnittes und eines dritten Balkenfederabschnittes der Balkenfederabschnitte verbunden ist, welche jeweils entlang des Randes des plattenförmigen Spiegels verlaufen und jeweils an dem zweiten Endbereich mit der geschlossenen Rahmenstruktur verbunden sind, und wobei der zweite Endbereich des ersten Balkenfederabschnittes mit den ersten Endbereichen eines vierten Balkenfederabschnittes und eines fünften Balkenfederabschnittes der Balkenfederabschnitte verbunden ist, welche entlang des Randes des plattenförmigen Spiegels verlaufen und jeweils an dem zweiten Endbereich mit dem plattenförmigen Spiegel verbunden sind.

Gemäß einer zweckmäßigen Weiterbildung der Erfindung sind der zweite Balkenfederabschnitt und der dritte Balkenfederabschnitt der H-förmigen Verbindungsfederstrukturen, welche jeweils entlang des Randes des plattenförmigen Spiegels verlaufen und jeweils an dem zweiten Endbereich mit der geschlossenen Rahmenstruktur verbunden sind, an ihrer dem Ursprung abgewandten Seite jeweils durch eine erste Öffnung von der geschlossenen Rahmenstruktur getrennt.

Gemäß einer vorteilhaften Weiterbildung der Erfindung sind der vierte Balkenfederabschnitt und der fünfte Balkenfederabschnitt der H-förmigen Verbindungsfederstrukturen, welche jeweils entlang des Randes des plattenförmigen Spiegels verlaufen und jeweils an dem zweiten Endbereich mit dem plattenförmigen Spiegel verbunden sind, an ihrer dem Ursprung zugewandten Seite jeweils durch eine Öffnung von dem plattenförmigen Spiegel getrennt.

Bei den H-förmigen Verbindungsfederstrukturen handelt es sich um solche Verbindungsfederstrukturen, welche zwei der oben beschriebenen T-förmigen Verbindungsfederstrukturen vereinen. Derartige H-förmige Verbindungsfederstrukturen können sowohl die Aufgabe einer Biegefeder als auch die Aufgabe einer Torsionsfeder übernehmen. Dabei hat sich gezeigt, dass sich derartige Verbindungsfederstrukturen günstig auf die dynamische Verformung des plattenförmigen Spiegels auswirken.

Gemäß einer vorteilhaften Weiterbildung der Erfindung umfasst die Federanordnung genau zwei Federstrukturen, welche so ausgebildet und angeordnet sind, dass die geschlossene Rahmenstruktur und der plattenförmige Spiegel rotatorisch um die x-Achse auslenkbar sind. Ein derart gelagerter plattenförmiger Spiegel wird auch als Kippspiegel bezeichnet. Rotatorische gelagerte Spiegel können beispielsweise in Projektionsdisplays, z.B. Retina Scanning Displays, in Lesegeräten für Muster und Bilder, z.B. Barcode-Lesegeräte, in Messgeräten, in Laserdruckern oder in Direkt-Belichtern eingesetzt werden.

Gemäß einer Weiterbildung der Erfindung umfasst die Verbindungsanordnung eine erste Verbindungsfederstrukturgruppe, welche einen Teil der Verbindungsfederstrukturen beinhaltet, und eine zweite Verbindungsfederstrukturgruppe, welche einen anderen Teil der Verbindungsfederstrukturen beinhaltet, wobei die Verbindungsfederstrukturen der ersten Verbindungsfederstrukturgruppe eine erste elastische Verformbarkeit aufweisen, wobei die Verbindungsfederstrukturen der zweiten Verbindungsfederstrukturgruppe eine zweite elastische Verformbarkeit aufweisen, und wobei sich die erste elastische Verformbarkeit und die zweite elastische Verformbarkeit unterscheiden. Eine derartige Bauform ist insbesondere bei rotatorisch gelagerten Spiegeln von Vorteil. In diesem Fall kann die erste Verbindungsfederstrukturgruppe in Bezug auf jene Kräfte und Momente optimiert werden, welche an oder benachbart zu der Rotationsachse zu übertragen sind, während die zweite Verbindungsfederstrukturgruppe in Bezug auf jene Kräfte und Momente optimiert werden kann, welche entfernt von der Rotationsachse zu übertragen sind. Auf diese Weise kann die dynamische Verformung des plattenförmigen Spiegels weiter verringert werden.

Gemäß einer zweckmäßigen Weiterbildung der Erfindung beinhaltet die erste Verbindungsfederstrukturgruppe zwei Verbindungsfederstrukturen der Verbindungsfederstrukturen, welche in dem Ruhezustand längs der x-Achse angeordnet und bezüglich der yz-Ebene spiegelsymmetrisch angeordnet sind.

Gemäß einer zweckmäßigen Weiterbildung der Erfindung beinhaltet die erste Verbindungsfederstrukturgruppe vier Verbindungsfederstrukturen der Verbindungsfederstrukturen, welche in dem Ruhezustand benachbart zu der der x-Achse angeordnet sind und bezüglich der xz-Ebene und der yz-Ebene spiegelsymmetrisch angeordnet sind.

Gemäß einer zweckmäßigen Weiterbildung der Erfindung beinhaltet die zweite Verbindungsfederstrukturgruppe zwei Verbindungsfederstrukturen der Verbindungsfederstrukturen, welche in dem Ruhezustand längs der y-Achse angeordnet und bezüglich der yz-Ebene spiegelsymmetrisch angeordnet sind.

Gemäß einer zweckmäßigen Weiterbildung der Erfindung beinhaltet die zweite Verbindungsfederstrukturgruppe vier Verbindungsfederstrukturen der Verbindungsfederstrukturen, welche in dem Ruhezustand benachbart zu der y-Achse angeordnet sind und bezüglich der xz-Ebene und der yz-Ebene spiegelsymmetrisch angeordnet sind.

Insgesamt hat sich gezeigt, dass Ausführungsbeispiele mit einer ersten Verbindungsfederstrukturgruppe und mit einer zweiten Verbindungsfederstrukturgruppe zu einer geringen dynamischen Verformung des plattenförmigen Spiegels führen.

Gemäß einer bevorzugten Weiterbildung der Erfindung umfasst die Federanordnung wenigstens zwei Federstrukturen, welche so ausgebildet und angeordnet sind, dass die geschlossene Rahmenstruktur und der plattenförmige Spiegel translatorisch in der Richtung der z-Achse auslenkbar sind. Ein derart gelagerter Spiegel wird auch als Pumpspiegel bezeichnet. Pumpspiegel kommen zum Beispiel im Bereich der Spektroskopie als Fourier-Transform-Spektrometer zum Einsatz.

Gemäß einer bevorzugten Weiterbildung der Erfindung umfasst die Verbindungsanordnung wenigstens vier Verbindungsfederstrukturen, welche eine selbe elastische Verformbarkeit aufweisen. Auf diese Weise kann ein translatorisch hin und her gehender Spiegels sicher gelagert werden, so dass die dynamische Formung des plattenförmigen Spiegels günstig beeinflusst wird.

Gemäß einer zweckmäßigen Weiterbildung der Erfindung entspricht eine Anzahl der Federstrukturen einer Anzahl von Verbindungsfederstrukturen, wobei die Federstrukturen und die Verbindungsfederstrukturen längs des Randes abwechselnd angeordnet sind. Auf diese Weise kann die dynamische Verformung des plattenförmigen Spiegels weiter verringert werden. Nach einer zweckmäßigen Weiterbildung der Erfindung ist längs des Randes des plattenförmigen Spiegels aus Richtung der z-Achse gesehen ein Abstand zwischen der geschlossenen Rahmenstruktur und dem plattenförmigen Spiegel zumindest außerhalb von Bereichen der Verbindungsfederstrukturen gleichbleibend. Auf diese Weise kann eine besonders kompakte Bauweise realisiert werden. Zudem wirkt sich eine derartige Bauform günstig auf die dynamische Verformung des plattenförmigen Spiegels aus.

Im Folgenden werden die vorliegende Erfindung und deren Vorteile anhand von Figuren näher beschrieben. Gleiche oder gleichartige Elemente oder Elemente mit gleicher oder äquivalenter Funktion sind im Folgenden mit gleichen oder gleichartigen Bezugszeichen versehen.

In der folgenden Beschreibung werden Ausführungsbeispiele mit einer Vielzahl von Merkmalen der vorliegenden Erfindung näher beschrieben, um ein besseres Verständnis der Erfindung zu vermitteln. Es ist jedoch festzuhalten, dass die vorliegende Erfindung auch unter Auslassung einzelner der beschriebenen Merkmale umgesetzt werden kann. Es sei auch darauf hingewiesen, dass die in verschiedenen Ausführungsbeispielen gezeigten Merkmale auch in anderer Weise kombinierbar sind, sofern dies nicht ausdrücklich ausgeschlossen ist oder zu Widersprüchen führen würde. Es zeigen:
- Fig. 1: eine mikromechanische Spiegelvorrichtung im Ruhezustand gemäß dem Stand der Technik in einer schematischen Aufsicht;
- Fig. 2: die mikromechanische Spiegelvorrichtung im Umkehrpunkt gemäß dem Stand der Technik in einer schematischen Seitenansicht;
- Fig. 3: ein erstes Ausführungsbeispiel einer erfindungsgemäßen mikromechanischen Spiegelvorrichtung im Ruhezustand in einer schematischen Aufsicht;
- Fig. 4: ein zweites Ausführungsbeispiel einer erfindungsgemäßen mikromechanischen Spiegelvorrichtung im Ruhezustand in einer schematischen Aufsicht;
- Fig. 5: ein drittes Ausführungsbeispiel einer erfindungsgemäßen mikromechanischen Spiegelvorrichtung im Ruhezustand in einer schematischen Aufsicht;
- Fig. 6: ein viertes Ausführungsbeispiel einer erfindungsgemäßen mikromechanischen Spiegelvorrichtung im Ruhezustand in einer schematischen Aufsicht;
- Fig. 7: ein fünftes Ausführungsbeispiel einer erfindungsgemäßen mikromechanischen Spiegelvorrichtung im Ruhezustand in einer schematischen Aufsicht;
- Fig. 8: das fünfte Ausführungsbeispiel einer erfindungsgemäßen mikromechanischen Spiegelvorrichtung im Umkehrpunkt in einer schematischen Seitenansicht;
- Fig. 9: eine Darstellung der an dem ausgelenkten fünften Ausführungsbeispiel wirkenden Kräfte und Momente in einer schematischen Seitenansicht;
- Fig. 10: ein sechstes Ausführungsbeispiel einer erfindungsgemäßen mikromechanischen Spiegelvorrichtung im Ruhezustand in einer schematischen Aufsicht;
- Fig. 11: das sechste Ausführungsbeispiel einer erfindungsgemäßen mikromechanischen Spiegelvorrichtung im Umkehrpunkt in einer schematischen Seitenansicht;
- Fig. 12: eine Darstellung der an dem sechsten ausgelenkten Ausführungsbeispiel wirkenden Kräfte in einer schematischen Seitenansicht;
- Fig. 13: eine perspektivische Ansicht der mikromechanischen Spiegelvorrichtung gemäß dem Stand der Technik;
- Fig. 14: eine Darstellung der dynamischen Deformation im Umkehrpunkt mittels Höhenlinien der mikromechanischen Spiegelvorrichtung gemäß dem Stand der Technik;
- Fig. 15: eine perspektivische Ansicht des dritten Ausführungsbeispiels im Ruhezustand einer erfindungsgemäßen mikromechanischen Spiegelvorrichtung;
- Fig. 16: eine Darstellung der dynamischen Deformation im Umkehrpunkt mittels Höhenlinien des dritten Ausführungsbeispiels einer erfindungsgemäßen mikromechanischen Spiegelvorrichtung;
- Fig. 17: ein Diagramm zur Darstellung der dynamischen Deformation entlang eines Schnitts A der mikromechanischen Spiegelvorrichtung gemäß dem Stand der Technik;
- Fig. 18: ein Diagramm zur Darstellung der dynamischen Deformation entlang eines Schnitts B des dritten Ausführungsbeispiels einer erfindungsgemäßen mikromechanischen Spiegelvorrichtung;
- Fig. 19: ein gemeinsames Diagramm zur Darstellung der dynamischen Deformation entlang eines Schnitts A der mikromechanischen Spiegelvorrichtung gemäß dem Stand der Technik und zur Darstellung der dynamischen Deformation entlang eines Schnitts B des dritten Ausführungsbeispiels einer erfindungsgemäßen mikromechanischen Spiegelvorrichtung.

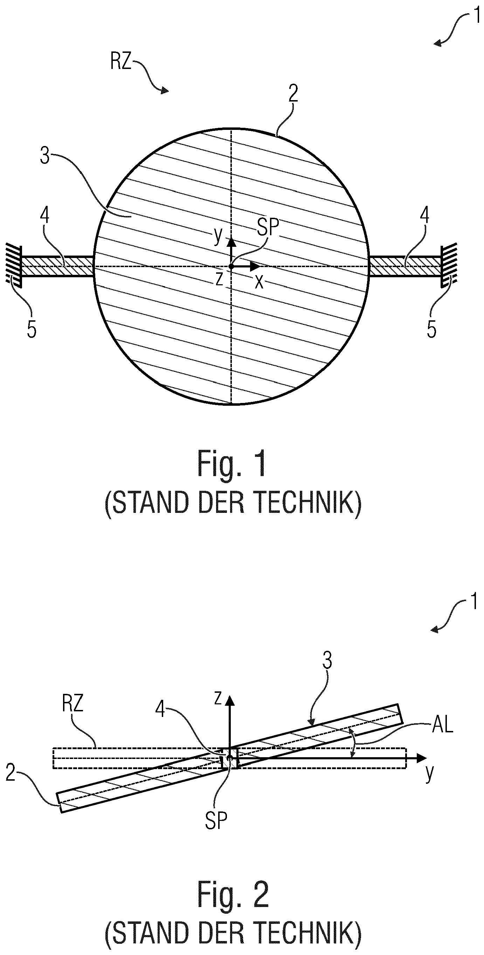

Fig. 1 zeigt eine mikromechanische Spiegelvorrichtung 1 gemäß dem Stand der Technik in einer schematischen Aufsicht. Die mikromechanische Spiegelvorrichtung 1 umfasst einen plattenförmigen Spiegel 2 mit einer Reflexionsfläche 3 zum Reflektieren von Licht der mittels zweier Federn 4 rotierbar an einer ortsfesten Tragstruktur 5 festgelegt ist. Der plattenförmige Spiegel 2 ist dabei in seinem Ruhezustand RZ gezeigt.

Fig. 2 zeigt die mikromechanische Spiegelvorrichtung 1 gemäß dem Stand der Technik in einer schematischen Seitenansicht. Der plattenförmige Spiegel 2 ist dabei um eine Auslenkung AL aus dem Ruhezustand RZ ausgelenkt.

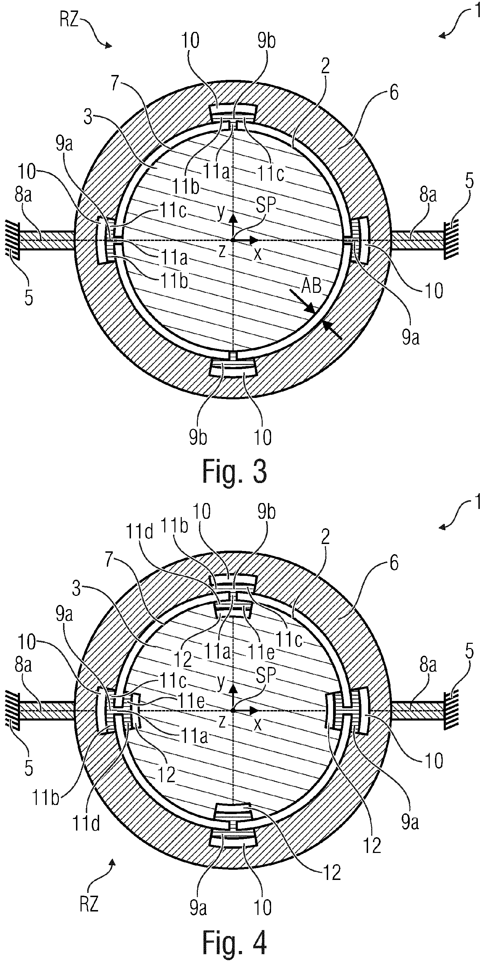

Fig. 3 zeigt ein erstes Ausführungsbeispiel einer erfindungsgemäßen mikromechanischen Spiegelvorrichtung 1 in einer schematischen Aufsicht. Die mikromechanische Spiegelvorrichtung 1 umfasst
einen plattenförmigen Spiegel 2 mit einer Reflexionsfläche 3 zum Reflektieren von Licht, wobei die Reflexionsfläche 3 in einem Ruhezustand RZ eben ausgebildet ist und parallel zu einer xy-Ebene eines eine x-Achse, eine y-Achse und eine z-Achse aufweisenden rechtwinkligen Koordinatensystems ausgerichtet ist, wobei in dem Ruhezustand RZ ein Schwerpunkt SP des plattenförmigen Spiegels 2 in einem Ursprung des Koordinatensystems liegt;
eine geschlossene Rahmenstruktur 6, welche den plattenförmigen Spiegel 2 trägt und welche in dem Ruhezustand RZ einen Rand 7 des plattenförmigen Spiegels 2 aus Richtung der z-Achse gesehen vollständig umrahmt;
eine Federanordnung mit mindestens zwei Federstrukturen 8, welche in dem Ruhezustand RZ bezüglich einer xz-Ebene des Koordinatensystems und einer yz-Ebene des Koordinatensystems spiegelsymmetrisch angeordnet sind und welche die geschlossene Rahmenstruktur 6 mit einer ortsfest in dem Koordinatensystem liegenden Tragstruktur 5 verbinden, wobei die Federanordnung so ausgebildet ist, dass die geschlossene Rahmenstruktur 6 und der plattenförmige Spiegel 2 gegenüber der Tragstruktur 5 mittels elektrostatischer, elektromagnetischer oder piezoelektrischer Kräfte in einen resonanten Schwingungszustand bringbar sind; und
eine Verbindungsanordnung mit mindestens vier Verbindungsfederstrukturen 9, welche in dem Ruhezustand bezüglich der xz-Ebene und der yz-Ebene spiegelsymmetrisch angeordnet sind, und welche jeweils den plattenförmigen Spiegel 2 mit der geschlossenen Rahmenstruktur 6 verbinden; wobei die Verbindungsfederstrukturen 9 derart elastisch verformbar ausgebildet und angeordnet sind, dass sie sich in dem resonanten Schwingungszustand hin und her verformen, so dass der plattenförmige Spiegel 2 von der geschlossenen Rahmenstruktur 6 teilweise mechanisch entkoppelt ist.

Der plattenförmige Spiegel 2 und die geschlossene Rahmenstruktur 6 sind im Ruhezustand RZ gezeigt.

Gemäß einer bevorzugten Weiterbildung der Erfindung sind wenigstens zwei Verbindungsfederstrukturen 9a der Verbindungsfederstrukturen 9 derart angeordnet und derart elastisch verformbar ausgebildet, dass sie in dem resonanten Schwingungszustand um eine aus Richtung der z-Achse gesehen quer zu dem Rand 7 des plattenförmigen Spiegels 2 verlaufende Torsionsachse hin und her tordieren. Die beiden Verbindungsfederstrukturen 9a sind sich gegenüberliegend an der x-Achse angeordnet und nehmen ausschließlich die Aufgabe einer Torsionsfeder wahr.

Gemäß einer bevorzugten Weiterbildung der Erfindung sind wenigstens zwei Verbindungsfederstrukturen 9b der Verbindungsfederstrukturen 9 derart angeordnet und derart elastisch verformbar ausgebildet, dass an der jeweiligen Verbindungsfederstruktur 9b in dem resonanten Schwingungszustand ein hin und her gehender Versatz zwischen der geschlossenen Rahmenstruktur 6 und dem plattenförmigen Spiegel 2 in einer parallel zu der z-Achse verlaufenden Versatzrichtung auftritt. Die beiden Verbindungsfederstrukturen 9b sind sich gegenüberliegend an der y-Achse angeordnet und nehmen ausschließlich die Aufgabe einer Biegefeder wahr.

Gemäß der Erfindung sind wenigstens zwei der Verbindungsfederstrukturen 9 an ihrer dem Ursprung abgewandten Seite jeweils durch eine erste Öffnung 10 von der geschlossenen Rahmenstruktur getrennt.

Gemäß der Erfindung sind, aus der Richtung der z-Achse gesehen, mindestens vier der Verbindungsfederstrukturen 9 derart T-förmig ausgebildet, dass sie jeweils drei Balkenfederabschnitte 11 mit jeweils einem ersten Endbereich und einem zweiten Endbereich aufweisen, wobei die drei Balkenfederabschnitte 11 an den ersten Endbereichen miteinander verbunden sind, wobei ein erster Balkenfederabschnitt 11a der Balkenfederabschnitte 11 quer zum Rand 7 des plattenförmigen Spiegels 2 verläuft.

Nach der Erfindung ist der erste Balkenfederabschnitt 11a an dem zweiten Endbereich mit dem plattenförmigen Spiegel 2 verbunden, wobei ein zweiter Balkenfederabschnitt 11b und ein dritter Balkenfederabschnitt 11c der Balkenfederabschnitte 11 jeweils entlang des Randes 7 des plattenförmigen Spiegels 2 verlaufen und jeweils an dem zweiten Endbereich mit der geschlossenen Rahmenstruktur 6 verbunden sind.

Nach der Erfindung sind die zweiten Balkenfederabschnitte 11b und die dritten Balkenfederabschnitte 11c der T-förmigen Verbindungsfederstrukturen 9, welche jeweils entlang des Randes 7 des plattenförmigen Spiegels 2 verlaufen, an ihrer dem Ursprung abgewandten Seite jeweils durch eine erste Öffnung 10 von der geschlossenen Rahmenstruktur 6 getrennt.

Nach einer nicht gezeigten zweckmäßigen Weiterbildung der Erfindung sind die zweiten Balkenfederabschnitte 11b und dritten Balkenfederabschnitte 11c der T-förmigen Verbindungsfederstrukturen 9, welche jeweils entlang des Randes 7 des plattenförmigen Spiegels 2 verlaufen, an ihrer dem Ursprung zugewandten Seite jeweils durch eine zweite Öffnung 12 von dem plattenförmigen Spiegel 2 getrennt.

Gemäß einer vorteilhaften Weiterbildung der Erfindung umfasst die Federanordnung genau zwei Federstrukturen 8a, welche so ausgebildet und angeordnet sind, dass die geschlossene Rahmenstruktur 6 und der plattenförmige Spiegel 2 rotatorisch um die x-Achse auslenkbar sind. Die Federanordnung kann dabei zwei sich auf der x-Achse gegenüberliegende Federstrukturen 8a umfassen, welche als Torsionsfederstrukturen ausgebildet sind, so dass der plattenförmige Spiegel 2 und die geschlossene Rahmenstruktur 6 mittels elektrischer Kräfte in einen rotatorischen resonanten Schwingungszustand gebracht werden können.

Nach einer zweckmäßigen Weiterbildung der Erfindung umfasst die Verbindungsanordnung eine erste Verbindungsfederstrukturgruppe, welche einen Teil der Verbindungsfederstrukturen 9 beinhaltet, und eine zweite Verbindungsfederstrukturgruppe, welche einen anderen Teil der Verbindungsfederstrukturen 9 beinhaltet, wobei die Verbindungsfederstrukturen 9a der ersten Verbindungsfederstrukturgruppe eine erste elastische Verformbarkeit aufweisen, wobei die Verbindungsfederstrukturen 9b der zweiten Verbindungsfederstrukturgruppe eine zweite elastische Verformbarkeit aufweisen, und wobei sich die erste elastische Verformbarkeit und die zweite elastische Verformbarkeit unterscheiden.

Gemäß einer vorteilhaften Weiterbildung der Erfindung beinhaltet die erste Verbindungsfederstrukturgruppe zwei Verbindungsfederstrukturen 9a der Verbindungsfederstrukturen 9, welche in dem Ruhezustand RZ längs der x-Achse angeordnet und bezüglich der yz-Ebene spiegelsymmetrisch angeordnet sind.

Gemäß einer zweckmäßigen Weiterbildung der Erfindung beinhaltet die zweite Verbindungsfederstrukturgruppe zwei Verbindungsfederstrukturen 9b der Verbindungsfederstrukturen 9, welche in dem Ruhezustand RZ längs der y-Achse angeordnet und bezüglich der yz-Ebene spiegelsymmetrisch angeordnet sind.

Gemäß einer zweckmäßigen Weiterbildung der Erfindung ist längs des Randes 7 des plattenförmigen Spiegels 2 aus Richtung der z-Achse gesehen ein Abstand AB zwischen der geschlossenen Rahmenstruktur 6 und dem plattenförmigen Spiegel 2 zumindest außerhalb von Bereichen der Verbindungsfederstrukturen 9 gleichbleibend.

Die beiden Verbindungsfederstrukturen 9a können dieselbe Elastizität aufweisen. Ebenso können die beiden Verbindungsfederstrukturen 9b dieselbe Elastizität aufweisen.

Bei dem erfindungsgemäßen Ausführungsbeispiel nach Fig. 3 wird ein rotatorisch um die x- Achse (oder translatorisch in z-Richtung auslenkbarer elliptischer plattenförmiger Spiegel 2) mithilfe von zwei Verbindungsfederstrukturen 9a und zwei Verbindungsfederstrukturen 9b mit der ringförmigen, geschlossenen Rahmenstruktur 6 verbunden. Hierbei können die Verbindungsfederstrukturen 9a und 9b bei rotatorischer Ausführung unterschiedliche Geometrieparameter bzw. Gesamtsteifigkeiten besitzen. Die Verbindungsfederstrukturen 9b sind in der y-Achse senkrecht zur Drehachse angeordnet. Demgegenüber liegen die Verbindungsfederstrukturen 9a in der x-Achse bzw. Drehachse des plattenförmigen Spiegels 2. Die insgesamt vier Verbindungsfederstrukturen 9 sind hier durch die definierten Öffnungen 10 derart T-förmig ausgestaltet, dass drei Balkenfederabschnitte 11a, 11b, 11c je Verbindungsfederstrukturen 9 entstehen, wobei zwei Balkenfederabschnitte 11b, 11c parallel und ein Balkenfederabschnitt senkrecht zum Rand 7 angeordnet sind. Der senkrechte Balkenfederabschnitt 11a ist hier mit dem plattenförmigen Spiegel 2 verbunden. Die Balkenfederabschnitte 11 besitzen definierte Torsions- und Biegesteifigkeiten. Die ringförmige, geschlossene Rahmenstruktur 6 wird über die in der Drehachse liegenden Federstrukturen 8a mit der als Anker ausgebildeten Tragstruktur 5 verbunden und der plattenförmige Spiegel 2 dadurch fest gelagert.

Fig. 4 zeigt ein zweites Ausführungsbeispiel einer erfindungsgemäßen mikromechanischen Spiegelvorrichtung 1 in einer schematischen Aufsicht. Das zweite Ausführungsbeispiel beruht auf dem ersten Ausführungsbeispiel, so dass im Folgenden nur die Unterschiede erläutert sind.

Nach einer zweckmäßigen Weiterbildung der Erfindung sind wenigstens zwei der Verbindungsfederstrukturen 9 an ihrer dem Ursprung zugewandten Seite jeweils durch eine zweite Öffnung 12 von dem plattenförmigen Spiegel 2 getrennt.

Nach einer zweckmäßigen Weiterbildung der Erfindung sind, aus der Richtung der z-Achse gesehen, mindestens zwei der Verbindungsfederstrukturen 9 derart H-förmig ausgebildet, dass sie jeweils fünf Balkenfederabschnitte 11 mit jeweils einem ersten Endbereich und einem zweiten Endbereich aufweisen, wobei ein erster Balkenfederabschnitt 11a der Balkenfederabschnitte 11 quer zum Rand 7 des plattenförmigen Spiegels 2 verläuft, wobei der erste Endbereich des ersten Balkenfederabschnittes 11a mit den ersten Endbereichen eines zweiten Balkenfederabschnittes 11b und eines dritten Balkenfederabschnittes 11c der Balkenfederabschnitte 11 verbunden ist, welche jeweils entlang des Randes 7 des plattenförmigen Spiegels 2 verlaufen und jeweils an dem zweiten Endbereich mit der geschlossenen Rahmenstruktur 6 verbunden sind, und wobei der zweite Endbereich des ersten Balkenfederabschnittes 11a mit den ersten Endbereichen eines vierten Balkenfederabschnittes 11d und eines fünften Balkenfederabschnittes 11e der Balkenfederabschnitte 11 verbunden ist, welche entlang des Randes 7 des plattenförmigen Spiegels 2 verlaufen und jeweils an dem zweiten Endbereich mit dem plattenförmigen Spiegel 2 verbunden sind.

Nach einer zweckmäßigen Weiterbildung der Erfindung sind der zweite Balkenfederabschnitt 11b und der dritte Balkenfederabschnitt 11c der H-förmigen Verbindungsfederstrukturen 9, welche jeweils entlang des Randes 7 des plattenförmigen Spiegels 2 verlaufen und jeweils an dem zweiten Endbereich mit der geschlossenen Rahmenstruktur 6 verbunden sind, an ihrer dem Ursprung abgewandten Seite jeweils durch eine erste Öffnung 10 von der geschlossenen Rahmenstruktur 6 getrennt.

Gemäß einer zweckmäßigen Weiterbildung der Erfindung sind der vierte Balkenfederabschnitt 11d und der fünfte Balkenfederabschnitt 11e der H-förmigen Verbindungsfederstrukturen 9, welche jeweils entlang des Randes 7 des plattenförmigen Spiegels 2 verlaufen und jeweils an dem zweiten Endbereich mit dem plattenförmigen Spiegel 2 verbunden sind, an ihrer dem Ursprung zugewandten Seite jeweils durch eine zweite Öffnung 12 von dem plattenförmigen Spiegel 2 getrennt.

Bei dem erfindungsgemäßen Ausführungsbeispiel nach Fig. 4 wird ein rotatorisch um die x- Achse (oder translatorisch in z-Richtung) auslenkbarer elliptischer plattenförmiger Spiegel 2 mithilfe von zwei Verbindungsfederstrukturen 9a und zwei Verbindungsfederstrukturen 9b mit der ringförmigen, geschlossenen Rahmenstruktur 6 verbunden. Hierbei können die Verbindungsfederstrukturen 9a und 9b bei rotatorischer Ausführung unterschiedliche Geometrieparameter bzw. Gesamtsteifigkeiten besitzen. Die Verbindungsfederstrukturen 9b sind in der y-Achse senkrecht zur Drehachse angeordnet. Demgegenüber liegen die Verbindungsfederstrukturen 9a in der x-Achse bzw. Drehachse des plattenförmigen Spiegels 2. Die insgesamt vier Verbindungsfederstrukturen 9 sind hier durch die definierten Öffnungen 10 und 12 derart ausgestaltet, dass fünf Balkenfederabschnitte 11a, 11b, 11c, 11d, 11e je Verbindungsfederstruktur 9 entstehen, wobei vier Balkenfederabschnitte 11b, 11c, 11d, 11e parallel und ein verbindendes Balkenfederabschnitt 11a senkrecht zum Rand 7 angeordnet sind. Die Balkenfederabschnitte 11 besitzen definierte Torsions- und Biegesteifigkeiten. Die ringförmige, geschlossene Rahmenstruktur 6 wird über die in der Drehachse liegenden Federstrukturen 8a mit der als Anker ausgebildeten Tragstruktur 5 verbunden und der plattenförmige Spiegel 2 dadurch fest gelagert.

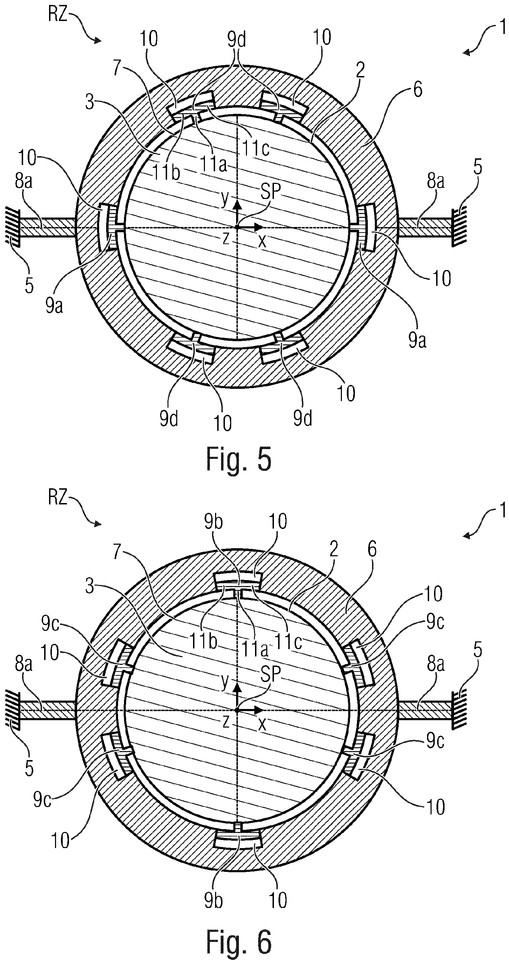

Fig. 5 zeigt ein drittes Ausführungsbeispiel einer erfindungsgemäßen mikromechanischen Spiegelvorrichtung 1 in einer schematischen Aufsicht. Das dritte Ausführungsbeispiel beruht auf dem ersten Ausführungsbeispiel, so dass im Folgenden nur die Unterschiede erläutert sind.

Die Verbindungsfederstrukturen 9a der Verbindungsfederstrukturen 9 sind derart angeordnet und derart elastisch verformbar ausgebildet, dass sie in dem resonanten Schwingungszustand um eine aus Richtung der z-Achse gesehen quer zu dem Rand 7 des plattenförmigen Spiegels 2 verlaufende Torsionsachse hin und her tordieren. Die beiden Verbindungsfederstrukturen 9a sind sich gegenüberliegend an der x-Achse angeordnet und nehmen ausschließlich die Aufgabe einer Torsionsfeder wahr.

Gemäß einer zweckmäßigen Weiterbildung der Erfindung beinhaltet die zweite Verbindungsfederstrukturgruppe vier Verbindungsfederstrukturen 9d der Verbindungsfederstrukturen 9, welche in dem Ruhezustand RZ benachbart zu der y-Achse angeordnet sind und bezüglich der xz-Ebene und der yz-Ebene spiegelsymmetrisch angeordnet sind.

Die vier Verbindungsfederstrukturen 9d können dieselbe Elastizität aufweisen.

Die Verbindungsfederstrukturen 9d der Verbindungsfederstrukturen 9 sind derart angeordnet und derart elastisch verformbar ausgebildet, dass an der jeweiligen Verbindungsfederstruktur 9b in dem resonanten Schwingungszustand ein hin und her gehender Versatz zwischen der geschlossenen Rahmenstruktur 6 und dem plattenförmigen Spiegel 2 in einer parallel zu der z-Achse verlaufenden Versatzrichtung auftritt, und dass sie in dem resonanten Schwingungszustand um eine aus Richtung der z-Achse gesehen quer zu dem Rand 7 des plattenförmigen Spiegels 2 verlaufende Torsionsachse hin und her tordieren. Die vier Verbindungsfederstrukturen 9d sind benachbart zu der y-Achse angeordnet und nehmen sowohl die Aufgabe einer Biegefeder als auch die Aufgabe einer Torsionsfeder wahr.

Bei dem erfindungsgemäßen Ausführungsbeispiel nach Fig. 5 wird ein rotatorisch um die x-Achse (oder translatorisch in z-Richtung) auslenkbarer plattenförmiger Spiegel 2 mithilfe von vier Verbindungsfederstrukturen 9d und zwei Verbindungsfederstrukturen 9a mit der ringförmigen, geschlossenen Rahmenstruktur 6 verbunden. Hierbei können die Verbindungsfederstrukturen 9d und 9a unterschiedliche Geometrieparameter bzw. Steifigkeiten besitzen. Die Verbindungsfederstrukturen 9d und 9a sind bezüglich beider Achsen symmetrisch angeordnet. Dabei liegen die Verbindungsfederstrukturen 9a in der x-Achse bzw. Drehachse des plattenförmigen Spiegels 2. Die insgesamt sechs Verbindungsfederstrukturen 9 sind hier durch die Öffnungen 10 derart T-förmig ausgestaltet, dass drei Balkenfederabschnitte 11a, 11b, 11c je Verbindungsfederstruktur 9 entstehen, wobei zwei Balkenfederabschnitte 11b, 11c jeweils parallel und ein Balkenfederabschnitt 11a senkrecht zum Rand 7 angeordnet sind. Das senkrechte Balkenfederabschnitt 11a ist hier mit dem plattenförmigen Spiegel 2 verbunden. Die Balkenfederabschnitte 11 besitzen definierte Torsions- und Biegesteifigkeiten und können in ihrer Form sowohl geradlinig, als auch gekrümmt sein, z.B. parallel der Form des äußeren Randes 7 des plattenförmigen Spiegels 2 ausgeführt sein. Die ringförmige, geschlossene Rahmenstruktur 6 wird über die in der Drehachse liegenden Federstrukturen 8a mit der als Anker ausgebildeten Tragstruktur 5 verbunden und der plattenförmige Spiegel 2 dadurch fest gelagert.

Fig. 6 zeigt ein viertes Ausführungsbeispiel einer erfindungsgemäßen mikromechanischen Spiegelvorrichtung 1 in einer schematischen Aufsicht. Das vierte Ausführungsbeispiel beruht auf dem ersten Ausführungsbeispiel, so dass im Folgenden nur die Unterschiede erläutert sind.

Die zweite Verbindungsfederstrukturgruppe beinhaltet zwei Verbindungsfederstrukturen 9b der Verbindungsfederstrukturen 9, welche in dem Ruhezustand RZ längs der y-Achse angeordnet und bezüglich der yz-Ebene spiegelsymmetrisch angeordnet sind.

Die Verbindungsfederstrukturen 9b der Verbindungsfederstrukturen 9 sind derart angeordnet und derart elastisch verformbar ausgebildet, dass an der jeweiligen Verbindungsfederstruktur 9b in dem resonanten Schwingungszustand ein hin und her gehender Versatz zwischen der geschlossenen Rahmenstruktur 6 und dem plattenförmigen Spiegel 2 in einer parallel zu der z-Achse verlaufenden Versatzrichtung auftritt. Die beiden Verbindungsfederstrukturen 9b sind sich gegenüberliegend an der y-Achse angeordnet und nehmen ausschließlich die Aufgabe einer Biegefeder wahr.

Gemäß einer vorteilhaften Weiterbildung der Erfindung beinhaltet die erste Verbindungsfederstrukturgruppe vier Verbindungsfederstrukturen 9c der Verbindungsfederstrukturen 9, welche in dem Ruhezustand RZ benachbart zu der der x-Achse angeordnet sind und bezüglich der xz-Ebene und der yz-Ebene spiegelsymmetrisch angeordnet sind.

Die vier Verbindungsfederstrukturen 9c können dieselbe Elastizität aufweisen.

Die Verbindungsfederstrukturen 9c der Verbindungsfederstrukturen 9 sind derart angeordnet und derart elastisch verformbar ausgebildet, dass an der jeweiligen Verbindungsfederstruktur 9c in dem resonanten Schwingungszustand ein hin und her gehender Versatz zwischen der geschlossenen Rahmenstruktur 6 und dem plattenförmigen Spiegel 2 in einer parallel zu der z-Achse verlaufenden Versatzrichtung auftritt, und dass sie in dem resonanten Schwingungszustand um eine aus Richtung der z-Achse gesehen quer zu dem Rand 7 des plattenförmigen Spiegels 2 verlaufende Torsionsachse hin und her tordieren. Die vier Verbindungsfederstrukturen 9c sind benachbart zu der y-Achse angeordnet und nehmen sowohl die Aufgabe einer Biegefeder als auch die Aufgabe einer Torsionsfeder wahr.

Bei dem erfindungsgemäßen Ausführungsbeispiel nach Fig. 6 wird ein rotatorisch um die x- Achse auslenkbarer plattenförmiger Spiegel 2 mithilfe von zwei Verbindungsfederstrukturen 9b und vier Verbindungsfederstrukturen 9c mit der ringförmigen, geschlossenen Rahmenstruktur 6 verbunden. Hierbei können die Verbindungsfederstrukturen 9b und 9c unterschiedliche Geometrieparameter bzw. Gesamtsteifigkeiten besitzen. Die Verbindungsfederstrukturen 9b und 9c sind bezüglich beider Achsen symmetrisch angeordnet. Dabei liegen die Verbindungsfederstrukturen 9b in der y-Achse (senkrecht zur Drehachse) des plattenförmigen Spiegels 2. Die insgesamt sechs Verbindungsfederstrukturen 9 sind hier durch die definierten Öffnungen 10 derart T-förmig ausgestaltet, dass drei Balkenfederabschnitte 11a, 11b, 11c je Verbindungsfederstruktur 9 entstehen, wobei zwei Balkenfederabschnitte 11b, 11c parallel und ein Balkenfederabschnitt 11a senkrecht zu Rand 7 angeordnet sind. Der senkrechte Balkenfederabschnitt 11a ist hier mit dem plattenförmigen Spiegel 2 verbunden. Die Balkenfederabschnitte 11 besitzen definierte Torsions- und Biegesteifigkeiten. Die ringförmige, geschlossene Rahmenstruktur 6 wird über die in der Drehachse liegenden Federstrukturen 8a mit der als Anker ausgebildeten Tragstruktur 5 verbunden und der plattenförmige Spiegel 2 dadurch fest gelagert.

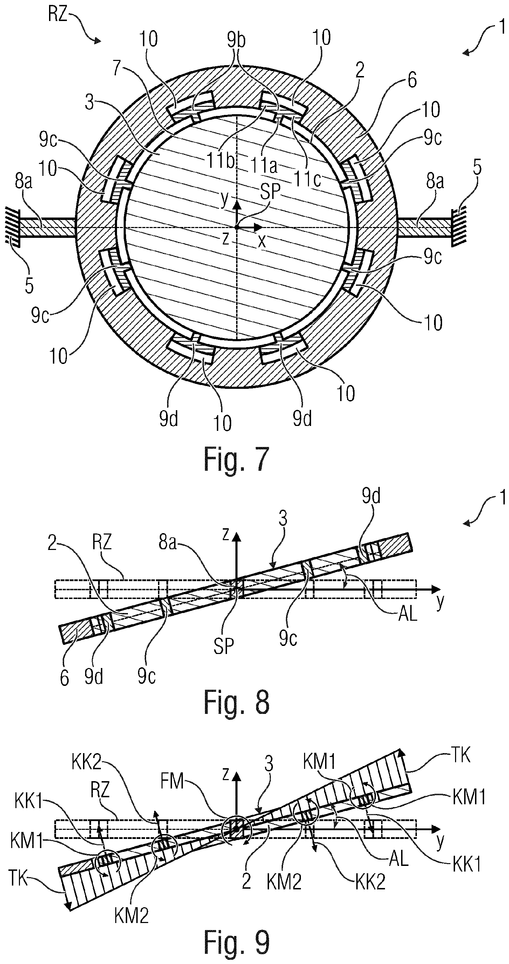

Fig. 7 zeigt ein fünftes Ausführungsbeispiel einer erfindungsgemäßen mikromechanischen Spiegelvorrichtung 1 in einer schematischen Aufsicht. Das fünfte Ausführungsbeispiel beruht auf dem dritten und vierten Ausführungsbeispiel, so dass im Folgenden nur die Unterschiede erläutert sind. Dabei umfasst die erste Verbindungsfederstrukturgruppe vier Verbindungsfederstrukturen 9c der Verbindungsfederstrukturen 9, welche wie oben beschrieben ausgeführt sind. Weiterhin umfasst die zweite Verbindungsfederstrukturgruppe vier Verbindungsfederstrukturen 9d der Verbindungsfederstrukturen 9, welche ebenfalls wie oben beschrieben ausgeführt sind.

Bei dem erfindungsgemäßen Ausführungsbeispiel nach Fig. 7 wird ein rotatorisch um die x- Achse (oder translatorisch in z-Richtung) auslenkbarer plattenförmiger Spiegel 2 mithilfe von vier Verbindungsfederstrukturen 9c und vier Verbindungsfederstrukturen 9d mit der ringförmigen, geschlossenen Rahmenstruktur 6 verbunden. Hierbei können die Verbindungsfederstrukturen 9c und 9d unterschiedliche Geometrieparameter bzw. Gesamtsteifigkeiten besitzen. Die Verbindungsfederstrukturen 9c und 9d sind bezüglich beider Achsen symmetrisch angeordnet, wobei die Verbindungsfederstrukturen 9d näher an der y-Achse und die Verbindungsfederstrukturen 9c näher an der x-Achse liegen. Die insgesamt acht Verbindungsfederstrukturen 9 sind durch die definierten Öffnungen 10 derart T-förmig ausgestaltet, dass drei Balkenfederabschnitte 11a, 11b, 11c je Verbindungsfederstruktur 9 entstehen, wobei zwei Balkenfederabschnitte 11b, 11c parallel und ein Balkenfederabschnitt 11a senkrecht zum Rand 7 angeordnet sind. Der senkrechte Balkenfederabschnitt 11a ist hier mit dem plattenförmigen Spiegel 2 verbunden. Die Balkenfederabschnitte 11 besitzen definierte Torsions- und Biegesteifigkeiten. Die ringförmige, geschlossene Rahmenstruktur 6 wird über die in der Drehachse liegenden Federstrukturen 8a mit der als Anker ausgebildeten Tragstruktur 5 verbunden und der plattenförmige Spiegel 2 dadurch fest gelagert.

Fig. 8 zeigt das fünfte Ausführungsbeispiel einer erfindungsgemäßen mikromechanischen Spiegelvorrichtung 1 in einer schematischen Seitenansicht. Der plattenförmige Spiegel 2 und der geschlossene Rahmen sind dabei um eine rotatorische Auslenkung AL aus dem Ruhezustand RZ ausgelenkt.

Fig. 9 zeigt eine Darstellung der an dem fünften Ausführungsbeispiel wirkenden Koppelkräfte KK, Trägheitskräfte TK, Federmomente FM und Koppelmomente KM in einer schematischen Seitenansicht. Dargestellt ist das Federmoment FM, welches durch eine Federstruktur 8a auf die geschlossene Rahmenstruktur 6 ausgeübt wird und der Auslenkung entgegengesetzt ist. Darüber hinaus sind die Koppelkräfte KK1 und die Koppelmomente KM1 gezeigt, welche verursacht durch die Federmomente FM von der geschlossenen Rahmenstruktur 6 mittels der die Verbindungsfederstrukturen 9d auf den plattenförmigen Spiegel 2 übertragen werden und somit ebenfalls der Auslenkung entgegen gesetzt sind. Ebenso sind die Koppelkräfte KK2 und die Koppelkräfte KM2 dargestellt, welche verursacht durch die Federmomente FM von der geschlossenen Rahmenstruktur 6 mittels der Verbindungsfederstrukturen 9c auf den plattenförmigen Spiegel 2 übertragen werden und der Auslenkung AL entgegengesetzt sind. Weiterhin sind die durch die beschleunigte Bewegung des plattenförmigen Spiegels 2 verursachten und über den gesamten plattenförmigen Spiegel 2 verteilten Trägheitskräfte TK dargestellt, die immer in Richtung der Auslenkung AL wirken. Die Größe dieser Trägheitskräfte TK ist vom Abstand zur Rotationsachse x des plattenförmigen Spiegels 2 abhängig und ist im Allgemeinen am äußersten Rand maximal und auf der Rotationsachse 0.

Es wird deutlich, dass die über die Verbindungsfederstrukturen 9 auf die Spiegelplatte 2 übertragenden Koppelkräfte KK den auf den plattenförmigen Spiegel 2 wirkenden Trägheitskräften TK entgegenwirken, wodurch sich die dynamische Verformung des plattenförmigen Spiegels 2 verringert. Der Effekt der Verringerung der dynamischen Deformation wird größer, wenn die Koppelkräfte KK im Größenbereich der Trägheitskräfte eingestellt werden. Dies lässt sich über die Anpassung der Steifigkeiten der Verbindungsfederstrukturen 9 durch eine gezielte Wahl der Geometrieparameter einerseits und einer angepassten Lage der Verbindungsfederstrukturen in der xy-Ebene entlang des Randes 7 andererseits erreichen. Der plattenförmige Spiegel 2 wird somit über die geschlossene Rahmenstruktur 6 und die Wahl der Verbindungsfederstrukturen 9 gezielt entkoppelt. Die ebenfalls auftretende dynamische Deformation der geschlossen Rahmenstruktur 6 kann im Vergleich zur überlagerten Deformation durch die Federstruktur 8a vernachlässigt werden. Die durch die Federstrukturen 8a verursachte Deformation der geschlossenen Rahmenstruktur 6 führt ihrerseits zu unerwünschten Koppelmomenten KM1 und KM2, die sich jedoch durch die Elastizität bezüglich Torsion der Verbindungsfederstrukturen 9c und 9d wesentlich geringer auf die Deformation der plattenförmigen Spiegelplatte 2 auswirken.

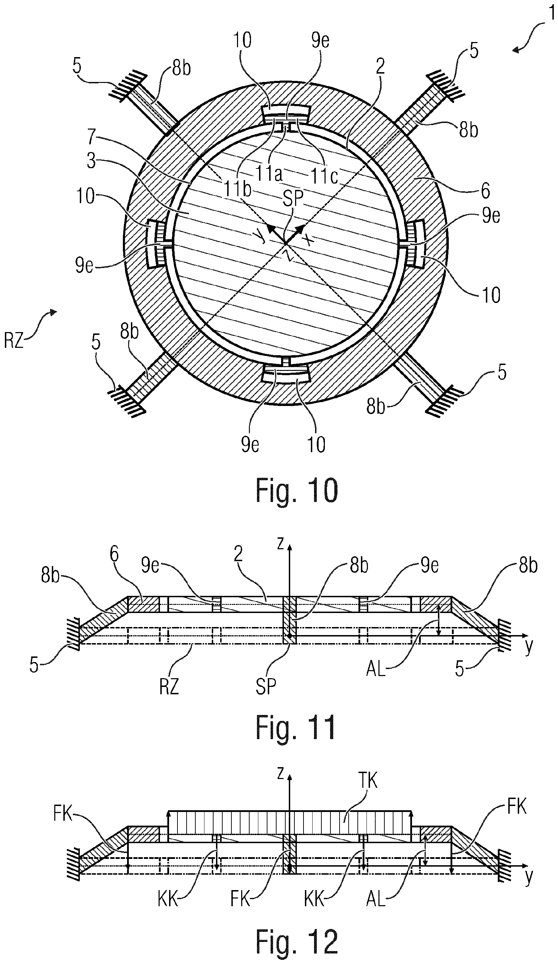

Fig. 10 zeigt ein sechstes Ausführungsbeispiel einer erfindungsgemäßen mikromechanischen Spiegelvorrichtung 1 in einer schematischen Aufsicht.

Das sechste Ausführungsbeispiel beruht auf den vorhergehenden Ausführungsbeispielen, so dass im Folgenden nur die Unterschiede erläutert sind. Gemäß einer vorteilhaften Weiterbildung der Erfindung umfasst die Federanordnung wenigstens zwei Federstrukturen 8b, welche so ausgebildet und angeordnet sind, dass die geschlossene Rahmenstruktur 6 und der plattenförmige Spiegel 2 translatorisch in der Richtung der z-Achse auslenkbar sind. Gemäß einer vorteilhaften Weiterbildung der Erfindung umfasst die Verbindungsanordnung wenigstens vier Verbindungsfederstrukturen 9e, welche eine selbe elastische Verformbarkeit aufweisen.

Gemäß einer zweckmäßigen Weiterbildung der Erfindung entspricht eine Anzahl der Federstrukturen 8 einer Anzahl von Verbindungsfederstrukturen 9, wobei die Federstrukturen 8 und die Verbindungsfederstrukturen 9 längs des Randes 7 abwechselnd angeordnet sind.

Bei dem erfindungsgemäßen Ausführungsbeispiel nach Fig. 10 wird ein translatorisch in z- Richtung auslenkbarer elliptischer plattenförmiger Spiegel 2 mithilfe von vier Verbindungsfederstrukturen 9e mit der ringförmigen, geschlossenen Rahmenstruktur 6 verbunden. Hierbei besitzen die Verbindungsfederstrukturen 9e gleiche Geometrieparameter bzw. Gesamtsteifigkeiten. Die Verbindungsfederstrukturen 9e sind in gleichen Abständen zueinander angeordnet und bezüglich der Hauptachse um 45° verdreht. Die insgesamt vier Verbindungsfederstrukturen 9 sind hier durch die definierten Öffnungen 10 derart T-förmig ausgestaltet, dass drei Balkenfederabschnitte 11a, 11b, 11c je Verbindungsfederstruktur 9 entstehen, wobei zwei 11b, 11c parallel und ein Balkenfederabschnitt 11a senkrecht zum Rand 7 angeordnet sind. Der senkrechte Balkenfederabschnitt 11a ist hier mit dem plattenförmigen Spiegel 2 verbunden. Die Balkenfederabschnitte 11 besitzen definierte Torsions- und Biegesteifigkeiten. Die ringförmige, geschlossene Rahmenstruktur 6 wird über vier in gleichen Abständen zueinander und in gleichen Abständen zu den Verbindungsfederstrukturen 9e angeordneten Federstrukturen 8b mit der als Anker ausgebildeten Tragstruktur 5 verbunden und der plattenförmige Spiegel 2 dadurch fest gelagert. Die vier Federstrukturen 8b sind dabei in den Hauptachsen angeordnet.

Fig. 11 zeigt das sechste Ausführungsbeispiel einer erfindungsgemäßen mikromechanischen Spiegelvorrichtung 1 in einer schematischen Seitenansicht. Der plattenförmige Spiegel 2 und der geschlossene Rahmen sind dabei um eine translatorische Auslenkung AL aus dem Ruhezustand RZ ausgelenkt.

Fig. 12 zeigt eine Darstellung der an dem sechsten Ausführungsbeispiel wirkenden Kräfte in einer schematischen Seitenansicht. Dargestellt sind die Federkräfte FK, welche durch die Federstrukturen 8b auf die geschlossene Rahmenstruktur 6 ausgeübt werden und der Auslenkung AL entgegengesetzt sind. Darüber hinaus sind die Koppelkräfte KK gezeigt, welche von den Federkräften verursacht und über die geschlossene Rahmenstruktur 6 durch die Verbindungsfederstrukturen 9e auf den plattenförmigen Spiegel 2 übertragen werden und ebenso der Auslenkung AL entgegengesetzt sind. Weiterhin sind die durch die beschleunigte Bewegung des plattenförmigen Spiegels 2 verursachten und gleichmäßig über den gesamten plattenförmigen Spiegel 2 verteilten Trägheitskräfte TK dargestellt, die in Richtung der Auslenkung AL wirken. Es wird deutlich, dass die über die Verbindungsfederstrukturen 9 auf den plattenförmigen Spiegel 2 übertragenden Koppelkräfte KK den auf den plattenförmigen Spiegel 2 wirkenden Trägheitskräften TK entgegenwirken, wodurch sich die dynamische Verformung des plattenförmigen Spiegels 2 verringert, wenn die Koppelkräfte KK im Größenbereich der Trägheitskräfte eingestellt werden. Dies lässt sich durch ein gezielte Entkopplung des plattenförmigen Spiegels 2 von den Federstrukturen 8b über die Anpassung der Steifigkeiten der Verbindungsfederstrukturen 9 zwischen der geschlossenen Rahmenstruktur 6 und des plattenförmigen Spiegels 2 durch die Wahl der Geometrieparameter einerseits und eine angepasste Lage der Verbindungsfederstrukturen in der xy-Ebene entlang des Randes 7 andererseits erreichen.

Dabei umfassen die Koppelmomente KM Anteile, welche durch eine dynamische Verformung der geschlossenen Rahmenstruktur 6 bedingt sind. Diese Anteile werden zumindest teilweise durch die Elastizität der Verbindungsfederstrukturen 9e ausgeglichen. Die Koppelmomente KM fallen daher durch die Elastizität der Verbindungsfederstrukturen 9e wesentlich kleiner aus, als dies bei einer starren Kopplung des plattenförmigen Spiegels 2 mit der geschlossenen Rahmenstruktur 6 der Fall wäre, so dass die dynamische Verformung des plattenförmigen Spiegels 2 verringert ist.

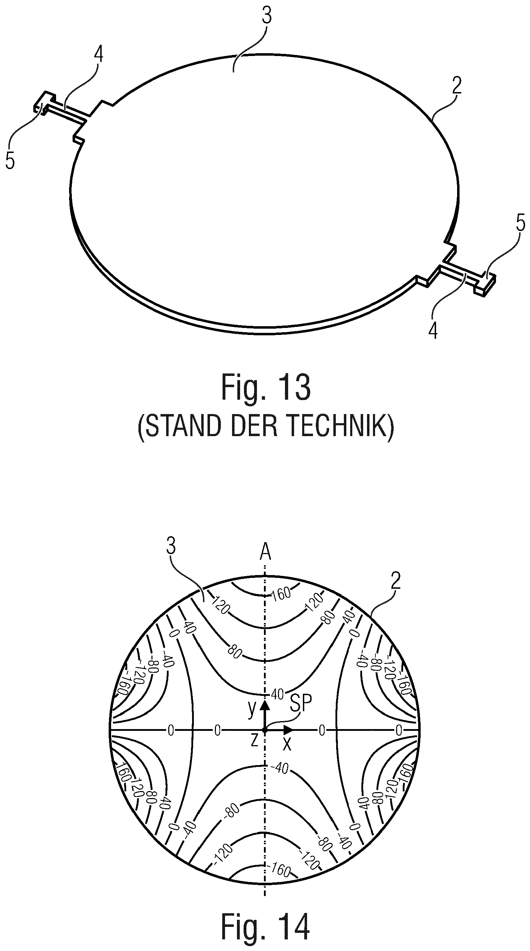

Fig. 13 zeigt eine perspektivische Ansicht der mikromechanischen Spiegelvorrichtung 1 in der Ruhelage gemäß dem Stand der Technik aus Fig. 1 mit einer Apertur von 3.5 mm und einer Resonanzfrequenz von 4000 Hz.

Fig. 14 zeigt beispielhaft eine Darstellung der dynamischen Deformation mittels Höhenlinien eines plattenförmigen Spiegels 2 einer mikromechanischen Spiegelvorrichtung 1 gemäß dem Stand der Technik aus Fig. 13 bei einer Auslenkung AL um die x-Achse von 1°. Das quadratische Mittel der dynamischen Verformung beträgt dabei 82 nm. Weiterhin beträgt die maximale Amplitude von Spitze zu Spitze der dynamischen Verformung 366 nm. Gut zu erkennen ist einerseits die der Auslenkung AL entgegengesetzte dynamische Deformation der plattenförmigen Spiegelplatte 2 im Bereich der Federstrukturen 4 aus Fig.13 im Bereich der Schnittpunkte von Rand 7 und x-Achse. Hier liegen die Werte der dynamischen Deformation im ersten Quadranten im negativen Bereich. Andererseits liegen Werte der hauptsächlich trägheitsbedingten dynamischen Deformationen im Bereich der Schnittpunkte von Rand 7 und y-Achse (im ersten Quadranten) im positiven Bereich, also in Richtung der Auslenkung.

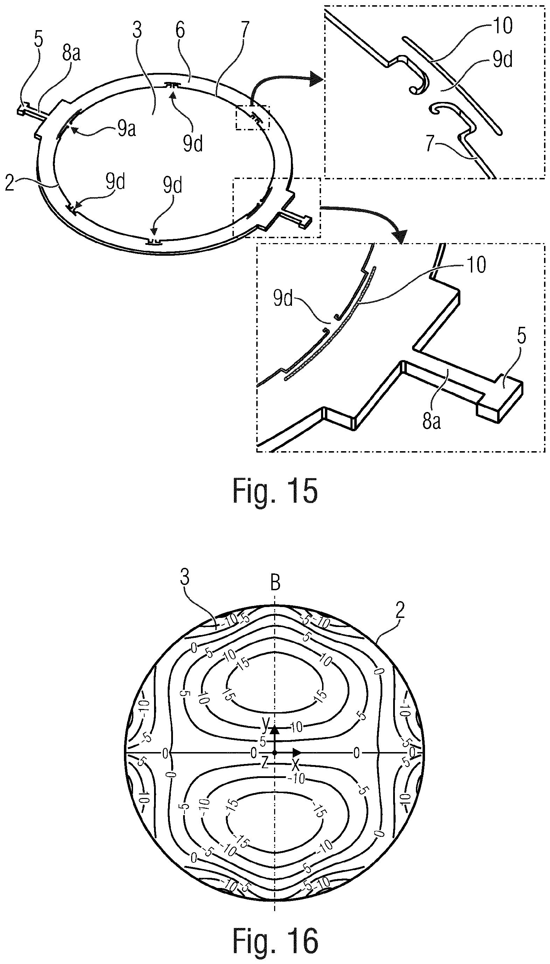

Fig. 15 zeigt eine perspektivische Ansicht des dritten Ausführungsbeispiels einer erfindungsgemäßen mikromechanischen Spiegelvorrichtung 1 aus Fig. 5. Dabei entspricht der plattenförmige Spiegel 2 hinsichtlich seiner Dicke, seines Materials und seines Durchmessers dem plattenförmigen Spiegel 2 der Figur 13, mit der gleichen Resonanzfrequenz des plattenförmigen Spiegels 2.

Fig. 16 zeigt eine Darstellung den optimierten Verlauf der dynamischen Deformation mittels Höhenlinien des dritten Ausführungsbeispiels einer erfindungsgemäßen mikromechanischen Spiegelvorrichtung 1 aus Fig. 15. Die Auslenkung AL beträgt ebenfalls 1°. Das quadratische Mittel der dynamischen Verformung beträgt nunmehr jedoch lediglich 9 nm und die maximale Amplitude von Spitze zu Spitze der dynamischen Verformung lediglich 38,6 nm. Deutlich zu erkennen ist die durch die Federstruktur eingekoppelte dynamische Deformation entlang des Randes 7, die der Auslenkung Al entgegengesetzt ist, d.h. negative Werte im ersten Quadranten. Demgegenüber zeigt der Bereich zwischen x-Achse und dem Schnittpunkt von Spiegelplattenrand und y-Achse eine dynamische Deformation in Richtung der Auslenkung AL, also positive Werte im ersten Quadranten.

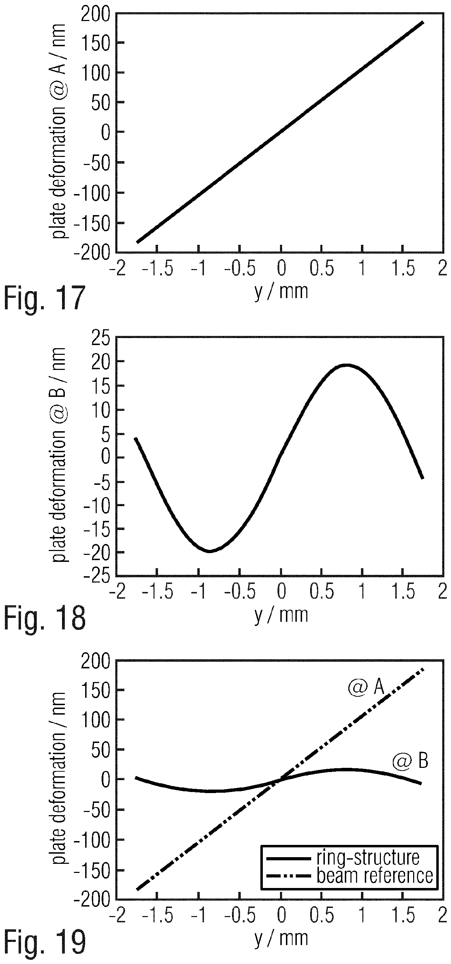

Fig. 17 zeigt ein Diagramm zur Darstellung der dynamischen Deformation der mikromechanischen Spiegelvorrichtung 1 gemäß dem Stand der Technik aus Fig. 13 entlang eines Schnitts A entlang der y-Achse. Die maximalen dynamischen Deformationen treten dabei am Rand 7 des plattenförmigen Spiegels 2 beidseitig des Schwerpunkts SP auf und betragen an der einen Seite -183 nm und an der anderen Seite + 183 nm.

Fig. 18 zeigt zur Verdeutlichung der Kompensation der beiden Deformationsanteile der dynamischen Deformation ein Diagramm zur Darstellung der dynamischen Deformation des dritten Ausführungsbeispiels der erfindungsgemäßen mikromechanischen Spiegelvorrichtung 1 aus Fig. 15 entlang eines Schnitts B entlang der y-Achse. Die maximalen dynamischen Deformationen treten dabei zwischen dem Schwerpunkt SP und dem Rand 7 des plattenförmigen Spiegels 2 beidseitig des Schwerpunkts SP auf und betragen auf der einen Seite - 19,3 nm und auf der anderen Seite +19,3 nm.

Fig. 19 ein gemeinsames Diagramm zur Darstellung der dynamischen Deformation entlang eines Schnitts A der mikromechanischen Spiegelvorrichtung 1 gemäß dem Stand der Technik und zur Darstellung der dynamischen Deformation entlang eines Schnitts B des dritten Ausführungsbeispiels einer erfindungsgemäßen mikromechanischen Spiegelvorrichtung 1. Fig. 19 zeigt dabei die Kurven der Fig. 17 und 18 im selben Maßstab. Eine deutliche Reduzierung der dynamischen Deformation um fast eine Größenordnung ist deutlich zu erkennen.

### Bezugszeichen:

- 1: mikromechanische Spiegelvorrichtung
- 2: plattenförmiger Spiegel
- 3: Reflexionsfläche
- 4: Feder zum Verbinden von Spiegel und Tragstruktur
- 5: Tragstruktur
- 6: geschlossene Rahmenstruktur
- 7: Rand
- 8: Federstruktur zum Verbinden von Rahmenstruktur und Tragstruktur
- 9: Verbindungsfederstruktur zum Verbinden von Spiegel und Rahmenstruktur
- 10: erste Öffnung
- 11: Balkenfederabschnitt
- 12: zweite Öffnung
- SP: Schwerpunkt
- RZ: Ruhezustand
- AB: Abstand
- AL: Auslenkung
- FM: Federmoment
- KK: Koppelkraft
- KM: Koppelmomente
- TK: Trägheitskräfte
- FK: Federkraft

### Quellen:

- [1]: DE 10 2004 037 833 A1
- [2]: DE 10 2005 033 800 A1
- [3]: US 7,301,692 B2
- [4]: US 7,256,919 B1
- [5]: US 8,345,336 B2
- [6]: US 2002/0041455 A1
- [7]: US 2013/0250390 A1
- [8]: EP 1 757 972 A1
- [9]: US 2014/028152 A1
- [10]: WO 2015/075222 A1
- [11]: US 2011/261431 A1

## Patentansprüche

1. Mikromechanische Spiegelvorrichtung umfassend:
einen plattenförmigen Spiegel (2) mit einer Reflexionsfläche (3) zum Reflektieren von Licht, wobei die Reflexionsfläche (3) in einem Ruhezustand (RZ) eben ausgebildet ist und parallel zu einer xy-Ebene eines eine x-Achse, eine y-Achse und eine z-Achse aufweisenden rechtwinkligen Koordinatensystems ausgerichtet ist, wobei in dem Ruhezustand (RZ) ein Schwerpunkt (SP) des plattenförmigen Spiegels (2) in einem Ursprung des Koordinatensystems liegt;
eine geschlossene Rahmenstruktur (6), welche den plattenförmigen Spiegel (2) trägt und welche in dem Ruhezustand (RZ) einen Rand (7) des plattenförmigen Spiegels (2) aus Richtung der z-Achse gesehen vollständig umrahmt;
eine ortsfest in dem Koordinatensystem liegende Tragstruktur (5);
eine Federanordnung mit mindestens zwei Federstrukturen (8), welche in dem Ruhezustand (RZ) bezüglich einer xz-Ebene des Koordinatensystems und einer yz-Ebene des Koordinatensystems spiegelsymmetrisch angeordnet sind und welche die geschlossene Rahmenstruktur (6) mit der Tragstruktur (5) verbinden, wobei die Federanordnung so ausgebildet ist, dass die geschlossene Rahmenstruktur (6) und der plattenförmige Spiegel (2) gegenüber der Tragstruktur (5) mittels elektrostatischer, elektromagnetischer oder piezoelektrischer Kräfte in einen resonanten Schwingungszustand bringbar sind; und
eine Verbindungsanordnung mit mindestens vier Verbindungsfederstrukturen (9), welche in dem Ruhezustand bezüglich der xz-Ebene und der yz-Ebene spiegelsymmetrisch angeordnet sind, und welche jeweils den plattenförmigen Spiegel (2) mit der geschlossenen Rahmenstruktur (6) verbinden; wobei die mindestens vier Verbindungsfederstrukturen (9) derart elastisch verformbar ausgebildet und angeordnet sind, dass sie sich in dem resonanten Schwingungszustand hin und her verformen, so dass der plattenförmige Spiegel (2) von der geschlossenen Rahmenstruktur (6) teilweise mechanisch entkoppelt ist;
**dadurch gekennzeichnet,**
**dass**, aus der Richtung der z-Achse gesehen, mindestens vier der mindestens vier Verbindungsfederstrukturen (9) derart T-förmig ausgebildet sind, dass sie jeweils drei Balkenfederabschnitte (11) mit jeweils einem ersten Endbereich und einem zweiten Endbereich aufweisen, wobei die drei Balkenfederabschnitte (11) an den ersten Endbereichen miteinander verbunden sind, wobei ein erster Balkenfederabschnitt (11a) der Balkenfederabschnitte (11) quer zum Rand (7) des plattenförmigen Spiegels (2) verläuft;
wobei der erste Balkenfederabschnitt (11a) an dem zweiten Endbereich mit dem plattenförmigen Spiegel (2) verbunden ist, und wobei ein zweiter Balkenfederabschnitt (11b) und ein dritter Balkenfederabschnitt (11c) der Balkenfederabschnitte (11) jeweils entlang des Randes (7) des plattenförmigen Spiegels (2) verlaufen und jeweils an dem zweiten Endbereich mit der geschlossenen Rahmenstruktur (6) verbunden sind;
wobei die zweiten Balkenfederabschnitte (11b) und die dritten Balkenfederabschnitte (11c) der mindestens vier T-förmigen Verbindungsfederstrukturen (9), welche jeweils entlang des Randes (7) des plattenförmigen Spiegels (2) verlaufen, an ihrer dem Ursprung abgewandten Seite jeweils durch eine erste Öffnung (10) von der geschlossenen Rahmenstruktur (6) getrennt sind.

2. Mikromechanische Spiegelvorrichtung nach vorstehendem Anspruch, wobei wenigstens zwei Verbindungsfederstrukturen (9a; 9c; 9d) der mindestens vier Verbindungsfederstrukturen (9) derart angeordnet und derart elastisch verformbar ausgebildet sind, dass sie in dem resonanten Schwingungszustand um eine aus Richtung der z-Achse gesehen quer zu dem Rand (7) des plattenförmigen Spiegels (2) verlaufende Torsionsachse hin und her tordieren.

3. Mikromechanische Spiegelvorrichtung nach einem der vorstehenden Ansprüche, wobei wenigstens zwei Verbindungsfederstrukturen (9b;9c; 9d; 9e) der mindestens vier Verbindungsfederstrukturen (9) derart angeordnet und derart elastisch verformbar ausgebildet sind, dass an der jeweiligen Verbindungsfederstruktur (9b;9c; 9d; 9e) in dem resonanten Schwingungszustand ein hin und her gehender Versatz zwischen der geschlossenen Rahmenstruktur (6) und dem plattenförmigen Spiegel (2) in einer parallel zu der z-Achse verlaufenden Versatzrichtung auftritt.

4. Mikromechanische Spiegelvorrichtung nach einem der vorstehenden Ansprüche, wobei die Federanordnung genau zwei Federstrukturen (8a) umfasst, welche so ausgebildet und angeordnet sind, dass die geschlossene Rahmenstruktur (6) und der plattenförmige Spiegel (2) rotatorisch um die x-Achse auslenkbar sind.

5. Mikromechanische Spiegelvorrichtung nach vorstehendem Anspruch, wobei die Verbindungsanordnung eine erste Verbindungsfederstrukturgruppe, welche einen Teil der mindestens vier Verbindungsfederstrukturen (9) beinhaltet, und eine zweite Verbindungsfederstrukturgruppe, welche einen anderen Teil der mindestens vier Verbindungsfederstrukturen (9) beinhaltet, umfasst, wobei die Verbindungsfederstrukturen (9a; 9c) der ersten Verbindungsfederstrukturgruppe eine erste elastische Verformbarkeit aufweisen, wobei die Verbindungsfederstrukturen (9b; 9d) der zweiten Verbindungsfederstrukturgruppe eine zweite elastische Verformbarkeit aufweisen, und wobei sich die erste elastische Verformbarkeit und die zweite elastische Verformbarkeit unterscheiden.

6. Mikromechanische Spiegelvorrichtung nach vorstehendem Anspruch, wobei die erste Verbindungsfederstrukturgruppe zwei Verbindungsfederstrukturen (9a) der mindestens vier Verbindungsfederstrukturen (9) beinhaltet, welche in dem Ruhezustand (RZ) längs der x-Achse angeordnet und bezüglich der yz-Ebene spiegelsymmetrisch angeordnet sind.

7. Mikromechanische Spiegelvorrichtung nach Anspruch 5, wobei die erste Verbindungsfederstrukturgruppe vier Verbindungsfederstrukturen (9c) der mindestens vier Verbindungsfederstrukturen (9) beinhaltet, welche in dem Ruhezustand (RZ) benachbart zu der x-Achse angeordnet sind und bezüglich der xz-Ebene und der yz-Ebene spiegelsymmetrisch angeordnet sind.

8. Mikromechanische Spiegelvorrichtung nach einem der Ansprüche 5 bis 7, wobei die zweite Verbindungsfederstrukturgruppe zwei Verbindungsfederstrukturen (9b) der mindestens vier Verbindungsfederstrukturen (9) beinhaltet, welche in dem Ruhezustand (RZ) längs der y-Achse angeordnet und bezüglich der yz-Ebene spiegelsymmetrisch angeordnet sind.

9. Mikromechanische Spiegelvorrichtung nach einem der Ansprüche 5 bis 7, wobei die zweite Verbindungsfederstrukturgruppe vier Verbindungsfederstrukturen (9d) der mindestens vier Verbindungsfederstrukturen (9) beinhaltet, welche in dem Ruhezustand (RZ) benachbart zu der y-Achse angeordnet sind und bezüglich der xz-Ebene und der yz-Ebene spiegelsymmetrisch angeordnet sind.

10. Mikromechanische Spiegelvorrichtung nach einem der Ansprüche 1 bis 3, wobei die Federanordnung wenigstens zwei Federstrukturen (8b) umfasst, welche so ausgebildet und angeordnet sind, dass die geschlossene Rahmenstruktur (6) und der plattenförmige Spiegel (2) translatorisch in der Richtung der z-Achse auslenkbar sind.

11. Mikromechanische Spiegelvorrichtung nach vorstehendem Anspruch, wobei die Verbindungsanordnung wenigstens vier Verbindungsfederstrukturen (9b; 9c; 9e) umfasst, welche eine selbe elastische Verformbarkeit aufweisen.

12. Mikromechanische Spiegelvorrichtung nach Anspruch 10 oder 11, wobei eine Anzahl der Federstrukturen (8) einer Anzahl der mindestens vier Verbindungsfederstrukturen (9) entspricht, wobei die Federstrukturen (8) und die mindestens vier Verbindungsfederstrukturen (9) längs des Randes (7) abwechselnd angeordnet sind.

13. Mikromechanische Spiegelvorrichtung nach einem der vorstehenden Ansprüche, wobei längs des Randes (7) des plattenförmigen Spiegels (2) aus Richtung der z-Achse gesehen ein Abstand (AB) zwischen der geschlossenen Rahmenstruktur (6) und dem plattenförmigen Spiegel (2) zumindest außerhalb von Bereichen der mindestens vier Verbindungsfederstrukturen (9) gleichbleibend ist.

## Claims

1. A micromechanical mirror device comprising:
a plate-shaped mirror (2) having a reflecting surface (3) for reflecting light, the reflecting surface (3) being configured to be planar in a rest state (RZ) and aligned in parallel to an xy plane of a rectangular coordinate system having an x-axis, a y-axis and a z-axis, wherein, in the rest state (RZ), a center of gravity (SP) of the plate-shaped mirror (2) is located in an origin of the coordinate system;
a closed frame structure (6) which supports the plate-shaped mirror (2) and which, in the rest state (RZ), completely frames an edge (7) of the plate-shaped mirror (2) as seen from the direction of the z axis;
a supporting structure (5) which is stationary in the coordinate system;
a spring arrangement having at least two spring structures (8) which, in the rest state (RZ), are arranged mirror-symmetrically with respect to an xz plane of the coordinate system and an yz plane of the coordinate system and which connect the closed frame structure (6) to the supporting structure (5), the spring arrangement being configured such that the closed frame structure (6) and the plate-shaped mirror (2) can be brought into a resonant vibrational state relative to the supporting structure (5) by means of electrostatic, electromagnetic or piezoelectric forces; and
a connecting arrangement having at least four connecting spring structures (9) which, in the rest state, are arranged mirror-symmetrically with respect to the xz plane and the yz plane and which each connect the plate-shaped mirror (2) to the closed frame structure (6); the at least four connecting spring structures (9) being configured to be elastically deformable and arranged in such a way that they deform back and forth in the resonant vibrational state, so that the plate-shaped mirror (2) is partially mechanically decoupled from the closed frame structure (6).
**characterized in that**,
as seen from the direction of the z axis, at least four of the at least four connecting spring structures (9) are T-shaped in such a way that they each comprise three beam spring portions (11) each having a first end region and a second end region, wherein the three beam spring portions (11) are connected to one another at the first end regions, wherein a first beam spring portion (11a) of the beam spring portions (11) extends transversely to the edge (7) of the plate-shaped mirror (2);
wherein the first beam spring portion (11a) is connected to the plate-shaped mirror (2) at the second end region, and wherein a second beam spring portion (11b) and a third beam spring portion (11c) of the beam spring portions (11) each extend along the edge (7) of the plate-shaped mirror (2) and are each connected to the closed frame structure (6) at the second end region;
wherein the second beam spring portions (11b) and the third beam spring portions (11c) of the T-shaped at least four connecting spring structures (9), which each extend along the edge (7) of the plate-shaped mirror (2), are separated from the closed frame structure (6) by a first opening (10) on their side facing away from the origin.

2. The micromechanical mirror device according to the preceding claim, wherein at least two connecting spring structures (9a; 9c; 9d) of the at least four connecting spring structures (9) are arranged and configured to be elastically deformable in such a way that, in the resonant vibrational state, they torsion back and forth about a torsion axis extending transversely to the edge (7) of the plate-shaped mirror (2) as seen from the direction of the z axis.

3. The micromechanical mirror device according to any of the preceding claims, wherein at least two connecting spring structures (9b; 9c; 9d; 9e) of the at least four connecting spring structures (9) are arranged and configured to be elastically deformable in such a way that, in the resonant vibrational state, a back and forth offset occurs between the closed frame structure (6) and the plate-shaped mirror (2) at the respective connecting spring structure (9b; 9c; 9d; 9e) in a direction of offset extending in parallel to the z-axis.

4. The micromechanical mirror device according to any of the preceding claims, wherein the spring arrangement comprises exactly two spring structures (8a) which are configured and arranged in such a way that the closed frame structure (6) and the plate-shaped mirror (2) can be deflected rotatably about the x axis.

5. The micromechanical mirror device according to the preceding claim, wherein the connecting arrangement comprises a first connecting spring structure group including a part of the at least four connecting spring structures (9) and a second connecting spring structure group including another part of the at least four connecting spring structures (9), wherein the connecting spring structures (9a; 9c) of the first connecting spring structure group have a first elastic deformability, wherein the connecting spring structures (9b; 9d) of the second connecting spring structure group have a second elastic deformability, and wherein the first elastic deformability and the second elastic deformability differ.

6. The micromechanical mirror device according to the preceding claim, wherein the first connecting spring structure group comprises two connecting spring structures (9a) of the at least four connecting spring structures (9) which, in the rest state (RZ), are arranged along the x-axis and are arranged mirror-symmetrically with respect to the yz plane.

7. The micromechanical mirror device according to claim 5, wherein the first connecting spring structure group comprises four connecting spring structures (9c) of the at least four connecting spring structures (9) which, in the rest state (RZ), are arranged adjacent to the x-axis and are arranged mirror-symmetrically with respect to the xz plane and the yz plane.

8. The micromechanical mirror device according to any of claims 5 to 7, wherein the second connecting spring structure group comprises two connecting spring structures (9b) of the at least four connecting spring structures (9) which, in the rest state (RZ), are arranged along the y-axis and are arranged mirror-symmetrically with respect to the yz plane.

9. The micromechanical mirror device according to any of claims 5 to 7, wherein the second connecting spring structure group comprises four connecting spring structures (9d) of the at least four connecting spring structures (9) which, in the rest state (RZ), are arranged adjacent to the y-axis and are arranged mirror-symmetrically with respect to the xz plane and the yz plane.

10. The micromechanical mirror device according to any of claims 1 to 3, wherein the spring arrangement comprises at least two spring structures (8b) which are configured and arranged such that the closed frame structure (6) and the plate-shaped mirror (2) can be deflected translationally in the direction of the z-axis.

11. The micromechanical mirror device according to the preceding claim, wherein the connecting arrangement comprises at least four connecting spring structures (9b; 9c; 9e) which have the same elastic deformability.

12. The micromechanical mirror device according to claim 10 or 11, wherein a number of the spring structures (8) corresponds to a number of the at least four connecting spring structures (9), wherein the spring structures (8) and the at least four connecting spring structures (9) are arranged alternately along the edge (7).

13. The micromechanical mirror device according to any of the preceding claims, wherein, as seen from the direction of the z axis, a distance (AB) between the closed frame structure (6) and the plate-shaped mirror (2) is constant along the edge (7) of the plate-shaped mirror (2), at least outside regions of the at least four connecting spring structures (9).

## Revendications

1. Dispositif de miroir micromécanique, comportant:
un miroir en forme de plaque (2) avec une surface réfléchissante (3) destinée à réfléchir de la lumière, où la surface réfléchissante (3) est réalisée plane dans un état de repos (RZ) et est orientée de manière parallèle à un plan xy d'un système de coordonnées à angle droit présentant un axe x, un axe y et un axe z, où, à l'état de repos (RZ), un centre de gravité (SP) du miroir en forme de plaque (2) se situe à une origine du système de coordonnées;
une structure de cadre fermée (6) qui porte le miroir en forme de plaque (2) et qui, à l'état de repos (RZ), entoure complètement un bord (7) du miroir en forme de plaque (2), vu depuis la direction de l'axe z;
une structure de support (5) qui est stationnaire dans le système de coordonnées;
un aménagement de ressorts avec au moins deux structures de ressort (8) qui, à l'état de repos (RZ), sont disposées en symétrie miroir par rapport à un plan xz du système de coordonnées et à un plan yz du système de coordonnées et qui connectent la structure de cadre fermée (6) à la structure de support (5), où l'aménagement de ressort est conçu de sorte que la structure de cadre fermée (6) et le miroir en forme de plaque (2) puissent être amenés, au moyen de forces électrostatiques, électromagnétiques ou piézoélectriques, dans un état d'oscillation résonnante par rapport à la structure de support (5); et
un aménagement de connexion avec au moins quatre structures de ressort de connexion (9) qui sont disposées, à l'état de repos, en symétrie miroir par rapport au plan xz et au plan yz, et qui connectent, chacune, le miroir en forme de plaque (2) à la structure de cadre fermée (6); où les au moins quatre structures de ressort de connexion (9) sont conçues et disposées de manière déformable élastiquement de sorte qu'elles se déforment dans un sens et dans l'autre à l'état d'oscillation résonnante, de sorte que le miroir en forme de plaque (2) soit partiellement découplé mécaniquement de la structure de cadre fermée (6);
**caractérisé par le fait**
**que**, vu depuis la direction de l'axe z, au moins quatre des au moins quatre structures de ressort de connexion (9) sont réalisées en forme de "T", de sorte qu'elles présentent, chacune, trois segments de ressort en forme de poutre (11) avec, chacun, une première zone d'extrémité et une deuxième zone d'extrémité, où les trois segments de ressort en forme de poutre (11) sont connectés l'un à l'autre aux premières zones d'extrémité, où un premier segment de ressort en forme de poutre (11a) des segments de ressort en forme de poutre (11) s'étend transversalement au bord (7) du miroir en forme de plaque (2);
dans lequel le premier segment de ressort en forme de poutre (11a) est connecté dans la deuxième zone d'extrémité au miroir en forme de plaque (2), et dans lequel un deuxième segment de ressort en forme de poutre (11b) et un troisième segment de ressort en forme de poutre (11c) des segments de ressort en forme de poutre (11) s'étendent, chacun, le long du bord (7) du miroir en forme de plaque (2) et sont connectés, chacun, dans la deuxième zone d'extrémité à la structure de cadre fermée (6);
dans lequel les deuxièmes segments de ressort en forme de poutre (11b) et les troisièmes segments de ressort en forme de poutre (11c) des au moins quatre structures de ressort de connexion en forme de "T" (9) qui s'étendent, chacun, le long du bord (7) du miroir en forme de plaque (2) sont séparés, chacun, de leur côté opposé à l'origine par une première ouverture (10) de la structure de cadre fermée (6).

2. Dispositif de miroir micromécanique selon la revendication précédente, dans lequel au moins deux structures de ressort de connexion (9a; 9c; 9d) des au moins quatre structures de ressort de connexion (9) sont disposées et conçues de manière déformable élastiquement de sorte qu'elles se tordent, à l'état d'oscillation résonnante, dans un sens et dans l'autre autour d'un axe de torsion s'étendant, vu depuis la direction de l'axe z, de manière transversale au bord (7) du miroir en forme de plaque (2).

3. Dispositif de miroir micromécanique selon l'une des revendications précédentes, dans lequel au moins deux structures de ressort de connexion (9b; 9c; 9d; 9e) des au moins quatre structures de ressort de connexion (9) sont disposées et conçues de manière déformable élastiquement de sorte qu'il se produise à la structure de ressort de connexion respective (9b; 9c; 9d; 9e), à l'état d'oscillation résonnante, un décalage dans un sens et dans l'autre entre la structure de cadre fermée (6) et le miroir en forme de plaque (2) dans une direction de décalage s'étendant de manière parallèle à l'axe z.

4. Dispositif de miroir micromécanique selon l'une des revendications précédentes, dans lequel l'aménagement de ressorts comporte exactement deux structures de ressort (8a) qui sont conçues et disposées de sorte que la structure de cadre fermée (6) et le miroir en forme de plaque (2) puissent être déviés en rotation autour de l'axe x.

5. Dispositif de miroir micromécanique selon la revendication précédente, dans lequel l'aménagement de connexion comporte un premier groupe de structures de ressort de connexion qui contient une partie des au moins quatre structures de ressort de connexion (9), et un deuxième groupe de structures de ressort de connexion qui contient une autre partie des au moins quatre structures de ressort de connexion (9), dans lequel les structures de ressort de connexion (9a; 9c) du premier groupe de structures de ressort de connexion présentent une première déformabilité élastique, dans lequel les structures de ressort de connexion (9b; 9d) du deuxième groupe de structures de ressort de connexion présentent une deuxième déformabilité élastique, et dans lequel la première déformabilité élastique et la deuxième déformabilité élastique sont différentes.

6. Dispositif de miroir micromécanique selon la revendication précédente, dans lequel le premier groupe de structures de ressort de connexion contient deux structures de ressort de connexion (9a) des au moins quatre structures de ressort de connexion (9) qui, à l'état de repos (RZ), sont disposées le long de l'axe x et sont disposées de manière symétrique en miroir par rapport au plan yz.

7. Dispositif de miroir micromécanique selon la revendication 5, dans lequel le premier groupe de structures de ressort de connexion contient quatre structures de ressort de connexion (9c) des au moins quatre structures de ressort de connexion (9) qui, à l'état de repos (RZ), sont disposées de manière adjacente à l'axe x et sont disposées de manière symétrique en miroir par rapport au plan xz et au plan yz.

8. Dispositif de miroir micromécanique selon l'une des revendications 5 à 7, dans lequel le deuxième groupe de structures de ressort de connexion contient deux structures de ressort de connexion (9b) des au moins quatre structures de ressort de connexion (9) qui, à l'état de repos (RZ), sont disposées le long de l'axe y et sont disposées de manière symétrique en miroir par rapport au plan yz.

9. Dispositif de miroir micromécanique selon l'une des revendications 5 à 7, dans lequel le deuxième groupe de structures de ressort de connexion contient quatre structures de ressort de connexion (9d) des au moins quatre structures de ressort de connexion (9) qui, à l'état de repos (RZ), sont disposées de manière adjacente à l'axe y et sont disposées de manière symétrique en miroir par rapport au plan xz et au plan yz.

10. Dispositif de miroir micromécanique selon l'une des revendications 1 à 3, dans lequel l'aménagement de ressorts comporte au moins deux structures de ressort (8b) qui sont conçues et disposées de sorte que la structure de cadre fermée (6) et le miroir en forme de plaque (2) puissent être déviés en translation dans la direction de l'axe z.

11. Dispositif de miroir micromécanique selon la revendication précédente, dans lequel l'aménagement de connexion comporte au moins quatre structures de ressort de connexion (9b; 9c; 9e) qui présentent la même déformabilité élastique.

12. Dispositif de miroir micromécanique selon la revendication 10 ou 11, dans lequel un nombre de structures de ressort (8) correspond à un nombre des au moins quatre structures de ressort de connexion (9), dans lequel les structures de ressort (8) et les au moins quatre structures de ressort de connexion (9) sont disposées en alternance le long du bord (7).

13. Dispositif de miroir micromécanique selon l'une des revendications précédentes, dans lequel le long du bord (7) du miroir en forme de plaque (2), vu depuis la direction de l'axe z, une distance (AB) entre la structure de cadre fermée (6) et le miroir en forme de plaque (2) est constante, du moins à l'extérieur des zones des au moins quatre structures de ressort de connexion (9).
